# EUROPEAN PATENT SPECIFICATION

(11) **EP 4 465 795 B1**
(45) Date of publication and mention of the grant of the patent: **29.04.2026**
(21) Application number: 23845464.9
(22) Date of filing: 21.07.2023
(51) Int. Cl.: H10K 59/131, H10D 86/40, H10D 86/60, H10K 59/121

(54) **DISPLAY SUBSTRATE AND DISPLAY APPARATUS**
ANZEIGESUBSTRAT UND ANZEIGEVORRICHTUNG
SUBSTRAT D'AFFICHAGE ET APPAREIL D'AFFICHAGE

(30) Priority: 28.07.2022 CN 202210898751
(43) Date of publication of application: 20.11.2024
(73) Proprietor: Boe Technology Group Co., Ltd., Beijing 100015 (CN); Chengdu BOE Optoelectronics Technology Co., Ltd., Chengdu, Sichuan 611731 (CN)
(72) Inventor: WANG, Mengqi, Beijing 100176 (CN); YU, Ziyang, Beijing 100176 (CN); JIANG, Zhiliang, Beijing 100176 (CN); HU, Ming, Beijing 100176 (CN); CHEN, Fei, Beijing 100176 (CN)
(74) Representative: Brötz, Helmut
(86) International application number: PCT/CN2023/108663
(87) International publication number: WO 2024/022254

(56) References cited:
- CN-A- 108 417 605
- CN-A- 113 160 742
- CN-A- 113 160 742
- CN-A- 113 160 743
- CN-A- 113 160 743
- CN-A- 113 823 642
- CN-A- 114 616 613
- CN-A- 115 224 097
- US-A1- 2019 378 859

## Description

### TECHNICAL FIELD

Embodiments of the present disclosure relate to a display substrate and a display apparatus.

### BACKGROUND

In the field of display technology, thin film transistors (TFTs) can include amorphous silicon (a-Si) TFT, low temperature poly-silicon (LTPS) TFT, oxide (e.g., indium gallium zinc oxide) TFT, and so on. Low temperature polycrystalline oxide (LTPO) is a low-power display technology. LTPO technology integrates low temperature poly-silicon technology and oxide technology to manufacture LTPS TFT and oxide TFT in the display panel, thus combining the advantages of LTPS TFT and the advantages of oxide TFT, making maximum use of the advantage of ultra-high mobility of low temperature poly-silicon and the advantage of small leakage current of oxide to achieve better display performance.

With people's continuous pursuit of visual effects of display products, narrow bezel and full-screen display have gradually become the current development trend of organic light-emitting diode (OLED) display products. CN 113160743 A discloses a display substrate comprising a first region located at a periphery of a second region, wherein a plurality of first and second signal lines are located on the first region, as known in the prior art.

### SUMMARY

The subject matter of the present invention is defined in claim 1. Embodiments of the present disclosure provide a display substrate and a display apparatus.

In an embodiment of the present disclosure, the display substrate includes a base substrate, and a plurality of first signal lines and a plurality of second signal lines on the base substrate. The base substrate includes a first region and a second region, the first region is located at a periphery of the second region; the plurality of first signal lines do not pass through the second region; the plurality of second signal lines are located in a different layer from the plurality of first signal lines, and do not pass through the second region. At least part of the plurality of first signal lines extends along a first direction, at least part of the plurality of second signal lines extends along a second direction, and the first direction intersects with the second direction; the plurality of first signal lines include part of first signal lines whose extension lines pass through the second region, each first signal line of the part of first signal lines includes a first sub-signal line and a second sub-signal line located on both sides of the second region, the first sub-signal line and the second sub-signal line are electrically connected through a first connection line extending in the first direction and a second connection line extending in the second direction, and the part of first signal lines are electrically connected with a plurality of first connection lines and a plurality of second connection lines; the plurality of second signal lines include part of second signal lines whose extension lines pass through the second region, each second signal line of the part of second signal lines includes a third sub-signal line and a fourth sub-signal line located on both sides of the second region, the third sub-signal line and the fourth sub-signal line are electrically connected through a third connection line extending in the first direction and a fourth connection line extending in the second direction, and the part of second signal lines are electrically connected with a plurality of third connection lines and a plurality of fourth connection lines; in a direction perpendicular to the base substrate, at least one second connection line overlaps with at least one third connection line, and on a same side of the second region, at least one first connection line is located on one side of at least one third connection line away from the second region.

For example, according to embodiments of the present disclosure, the plurality of first signal lines include a data line, and the plurality of second signal lines at least include a light-emitting control signal line.

For example, according to embodiments of the present disclosure, a minimum distance between one fourth connection line closest to the second region and an edge of the second region is less than a minimum distance between one first connection line closest to the second region and an edge of the second region.

For example, according to embodiments of the present disclosure, on a same side of the second region, a first group of connection lines among the plurality of second connection lines are located on one side of at least one fourth connection line close to the second region, and a second group of connection lines among the plurality of second connection lines are located on one side of the at least one fourth connection line away from the second region.

For example, according to embodiments of the present disclosure, in the direction perpendicular to the base substrate, the first group of connection lines overlap with the third connection line, and the second group of connection lines do not overlap with the third connection line.

For example, according to embodiments of the present disclosure, a distance between one second connection line closest to the second group of connection lines in the first group of connection lines and one second connection line closest to the first group of connection lines in the second group of connection lines is a first distance, a distance between two adjacent second connection lines in the second group of connection lines is a second distance, and a ratio of the first distance to the second distance is greater than 2.

For example, according to embodiments of the present disclosure, the first connection line connected with the one second connection line closest to the second group of connection lines in the first group of connection lines includes two portions respectively located on both sides of the one second connection line in the first direction.

For example, according to embodiments of the present disclosure, the first connection line connected with the one second connection line closest to the second group of connection lines in the first group of connection lines extends to a position of one second connection line closest to the first group of connection lines in the second group of connection lines.

For example, according to embodiments of the present disclosure, each first connection line among N first connection lines respectively connected with N second connection lines closest to the second group of connection lines in the first group of connection lines includes two portions respectively located on both sides of a second connection line connected with the each first connection line in the first direction; among the N first connection lines arranged along a direction approaching the second region, a length of a portion of the first connection line located on one side, close to the second group of connection lines, of the second connection line connected with the first connection line is gradually reduced, where N is a positive integer greater than or equal to 1, and a count of second connection lines in the first group of connection lines located on one side of a center of the second region is greater than or equal to N.

For example, according to embodiments of the present disclosure, one second signal line closest to the second region among part of the plurality of second signal lines whose extension lines do not pass through the second region is located between one fourth connection line closest to the second region and another fourth connection line adjacent to the one fourth connection line.

For example, according to embodiments of the present disclosure, on a same side of the second region, at least one first signal line whose extension line does not pass through the second region among the plurality of first signal lines is located on one side of the first connection line close to the second region.

For example, according to embodiments of the present disclosure, a ratio of a distance between one first connection line and one third connection line which are closest to each other among the plurality of first connection lines and the plurality of third connection lines to a distance between two adjacent third connection lines ranges from 0.8 to 1.2.

For example, according to embodiments of the present disclosure, in the first region, at least one first connection line and at least one third connection line are in a same layer, and at least one second connection line and at least one fourth connection line are in a same layer.

For example, according to embodiments of the present disclosure, at least one first connection line and at least one third connection line are located in the same layer as the plurality of first signal lines.

For example, according to embodiments of the present disclosure, the plurality of second signal lines are located between the plurality of first signal lines and the base substrate, and the fourth connection line is located between the plurality of first signal lines and the plurality of second signal lines.

For example, according to embodiments of the present disclosure, the first region is a display region, the first region surrounds the second region, the base substrate further includes a peripheral region surrounding the display region, the plurality of second group connection lines include the second connection line located in the first region and the second connection line located in the peripheral region, the second connection line located in the first region is arranged in a different layer from the first connection line, and the second connection line located in the peripheral region is arranged in the same layer as the first connection line.

For example, according to embodiments of the present disclosure, the second connection line located in the peripheral region is arranged in the same layer as the first signal line.

For example, according to embodiments of the present disclosure, at least one second connection line in the first group of connection lines and at least one fourth connection line are arranged in the same layer as and spaced apart from each other, and are located on a same straight line.

For example, according to embodiments of the present disclosure, on a same side of the second region, at least one first signal line connected with the second group of connection lines overlaps with each fourth connection line in the direction perpendicular to the base substrate.

For example, according to embodiments of the present disclosure, an orthographic projection of each first connection line on a straight line extending along the first direction overlaps with an orthographic projection of each third connection line on the straight line; and an orthographic projection of at least one second connection line on a straight line extending along the second direction does not overlap with an orthographic projection of at least one fourth connection line on the straight line.

For example, according to embodiments of the present disclosure, the display substrate further includes: a light-emitting element and a pixel circuit located on the base substrate, the pixel circuit being electrically connected with the light-emitting element. The pixel circuit includes a driving transistor, a light-emitting control transistor and a reset transistor, a gate electrode of the light-emitting control transistor is electrically connected with the light-emitting control signal line, a first electrode of the light-emitting control transistor is electrically connected with a first electrode of the driving transistor, and a second electrode of the light-emitting control transistor is electrically connected with the light-emitting element; a gate electrode of the reset transistor is electrically connected with a reset control signal line, and one electrode of the reset transistor is electrically connected with a second electrode of the driving transistor, or one electrode of the reset transistor is electrically connected with the second electrode of the light-emitting control transistor; the plurality of second signal lines include the reset control signal line.

For example, according to embodiments of the present disclosure, the display substrate further includes: a light-emitting element and a pixel circuit located on the base substrate, the pixel circuit being electrically connected with the light-emitting element; wherein the pixel circuit includes at least one N-type thin film transistor and at least one **P-**type thin film transistor; the plurality of second signal lines include a signal line connected with a gate electrode of the at least one P-type thin film transistor.

For example, according to embodiments of the present disclosure, , the display substrate further includes: a light-emitting element and a pixel circuit located on the base substrate, the pixel circuit being electrically connected with the light-emitting element; wherein the pixel circuit includes at least one oxide thin film transistor and at least one low temperature poly-silicon thin film transistor; the plurality of second signal lines include a signal line connected with a gate electrode of the at least one low temperature poly-silicon thin film transistors.

For example, according to embodiments of the present disclosure, the first region is a display region, the first region surrounds the second region, the base substrate further includes a peripheral region surrounding the display region; the display substrate further includes a plurality of fifth connection lines extending along the first direction and a plurality of sixth connection lines extending along the second direction, the fifth connection line located in the same layer and on the same straight line as the first connection line is spaced apart from the first connection line, the fifth connection line located in the same layer and on the same straight line as the third connection line is spaced apart from the third connection line, the sixth connection line located in the same layer and on the same straight line as the second connection line is spaced apart from the second connection line, the sixth connection line located in the same layer and on the same straight line as the fourth connection line is spaced apart from the fourth connection line, at least one of the fifth connection line and the sixth connection line is electrically connected with a third signal line, and the third signal line is located in the peripheral region.

For example, according to embodiments of the present disclosure, at least one of an interval between the fifth connection line and the first connection line and an interval between the fifth connection line and the third connection line overlaps with a film layer where the fourth connection line is located, and at least one of an interval between the sixth connection line and the second connection line and an interval between the sixth connection line and the fourth connection line overlaps with a film layer where the first connection line is located.

For example, according to embodiments of the present disclosure, at least one first connection line is provided on both sides thereof with two first signal lines immediately adjacent to this first connection line, and a minimum distance ratio between the two first signal lines and the first connection line ranges from 0.9 to 1.1; at least one third connection line is provided on both sides thereof with two first signal lines immediately adjacent to this third connection line, and a minimum distance ratio between the two first signal lines and the third connection line ranges from 0.9 to 1.1.

Another embodiment of the present disclosure provides a display apparatus which includes the display substrate as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
FIG. 1 is a partial planar view of a display substrate provided by an embodiment of the present disclosure.
FIG. 2 is an equivalent circuit diagram of a pixel circuit according to an embodiment of the present disclosure.
FIGS. 3A-3H include schematic diagrams of different film layers in a pixel circuit.
FIG. 3I is a schematic diagram of a stack of the film layers shown in FIGS. 3A-3F.
FIG. 4 is a partial planar structural view provided by another example of an embodiment of the present disclosure.
FIG. 5 is a schematic diagram of partial film layers in a region E1 shown in FIG. 4.
FIGS. 6 and 7 are schematic diagrams of two conductive layers at the position shown in FIG. 5.
FIG. 8 is a schematic diagram of partial film layers in a region E2 shown in FIG. 4.
FIGS. 9 and 10 are schematic diagrams of two conductive layers at the position shown in FIG. 8.
FIG. 11 is a schematic diagram of partial film layers in a region E3 shown in FIG. 4.
FIG. 12 is a schematic diagram of partial film layers in a region E4 shown in FIG. 4.
FIG. 13 is a schematic diagram of partial film layer including the region E1 shown in FIG. 4.
FIGS. 14 and 15 are schematic diagrams of two conductive layers at the position shown in FIG. 13.
FIG. 16 is a schematic diagram of partial film layers in a region E5 shown in FIG. 1.
FIG. 17 is a schematic diagram of partial film layers in a region E6 shown in FIG. 16.
FIG. 18 is a schematic diagram of partial film layers in a region E7 shown in FIG. 16.
FIG. 19 is a schematic diagram of a partial structure of a region E8 shown in FIG. 4.
FIG. 20 is a schematic diagram of a partial structure of a region E9 shown in FIG. 19.
FIGS. 21-25 are schematic diagrams of different film layers at the position shown in FIG. 20.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects.

The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "substantially the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two. The "same layer" in the embodiments of the present disclosure refers to the relationship between a plurality of film layers formed of the same material through the same step (e.g., one-step patterning process). The "same layer" herein does not always mean that the plurality of film layers have the same thickness or that the plurality of film layers have the same height in cross-sectional view.

The embodiments of the present disclosure provide a display substrate and a display apparatus. The display substrate includes a base substrate, and a plurality of first signal lines and a plurality of second signal lines located on the base substrate. The base substrate includes a first region and a second region, the first region is located at a periphery of the second region; the plurality of first signal lines are located on the base substrate and do not pass through the second region; the plurality of second signal lines are located in a different layer from the plurality of first signal lines, and do not pass through the second region. At least part of the plurality of first signal lines extends along a first direction, at least part of the plurality of second signal lines extends along a second direction, and the first direction intersects with the second direction; the plurality of first signal lines include part of first signal lines whose extension lines pass through the second region, each first signal line of the part of first signal lines includes a first sub-signal line and a second sub-signal line located on both sides of the second region, the first sub-signal line and the second sub-signal line are electrically connected through a first connection line extending in the first direction and a second connection line extending in the second direction, and the part of first signal lines are electrically connected with a plurality of first connection lines and a plurality of second connection lines; the plurality of second signal lines include part of second signal lines whose extension lines pass through the second region, each second signal line of the part of second signal lines includes a third sub-signal line and a fourth sub-signal line located on both sides of the second region, the third sub-signal line and the fourth sub-signal line are electrically connected through a third connection line extending in the first direction and a fourth connection line extending in the second direction, and the part of second signal lines are electrically connected with a plurality of third connection lines and a plurality of fourth connection lines; in the direction perpendicular to the base substrate, at least one second connection line overlaps with at least one third connection line, and on a same side of the second region, at least one first connection line is located on one side of at least one third connection line away from the second region.

In the display substrate provided by the embodiment of the present disclosure, the signal lines located on both sides of the second region are connected by using the first connection line, the second connection line, the third connection line and the fourth connection line, and the second connection line overlaps with the third connection line, while the first connection line is located on one side of the third connection line away from the second region, so that the wiring space around the second region can be reduced to increase the area of the display region, and the load sudden change of the first signal line and the second signal line can be reduced.

The display substrate and the display apparatus provided by the embodiments of the present disclosure will be described below with reference to the accompanying drawings.

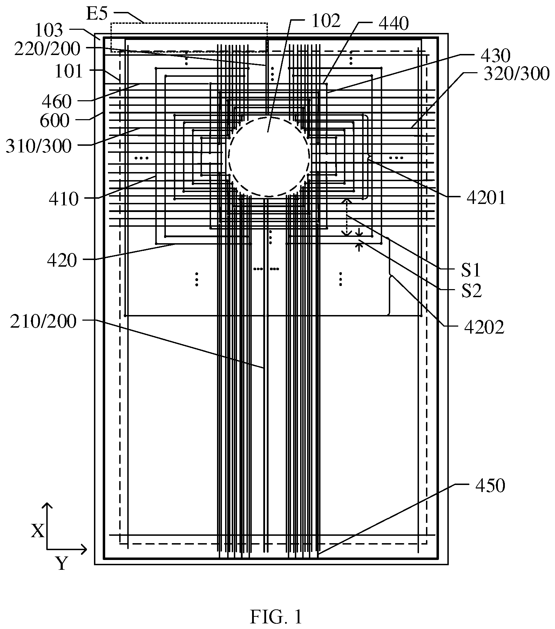

FIG. 1 is a partial planar view of a display substrate provided by an embodiment of the present disclosure. As shown in FIG. 1, the display substrate includes a base substrate 100, and a plurality of first signal lines 200 and a plurality of second signal lines 300 located on the base substrate 100. The base substrate 100 includes a first region 101 and a second region 102, and the first region 101 is located at a periphery of the second region 102. For example, FIG. 1 illustratively shows that the first region 101 surrounds the second region 102, but it is not limited thereto, and the first region 101 may only be located at a part of the periphery of the second region 102, and for example, the first region 101 only surrounds a part of the second region 102.

For example, as shown in FIG. 1, the first region 101 is a display region, and the second region 102 can be a hole region located in the first region 101. For example, the second region 102 can be a display region or a non-display region. For example, the second region 102 is a region where no signal line passes through. For example, the edge of the second region 102 can be the edge of the hole region. For example, at least part of the edge of the second region 102 is not parallel to either the first direction or the second direction. For example, the shape of the second region 102 can be a circle or an ellipse. But not limited thereto, the shape of the second region 102 can be a polygon, such as a quadrilateral, a hexagon, or an octagon, etc. For example, the shape of the first region 101 can be a quadrilateral, such as a rectangle. But not limited thereto, the shape of the first region 101 can also be a circle, or any other polygon other than a quadrilateral, such as a hexagon, an octagon, etc.

As shown in FIG. 1, the plurality of first signal lines 200 do not pass through the second region 102; the plurality of second signal lines 300 are located in a different layer from the plurality of first signal lines 200, and do not pass through the second region 102. For example, each first signal line 200 does not pass through the second region 102, and each second signal line 300 does not pass through the second region 102. For example, the plurality of first signal lines 200 that do not pass through the second region 102 include first signal lines 200 whose extension lines do not pass through the second region 102 and first signal lines 200 whose extension lines pass through the second region 102; the plurality of second signal lines 300 that do not pass through the second region 102 include second signal lines 300 whose extension lines do not pass through the second region 102 and second signal lines 300 whose extension lines pass through the second region 102.

As shown in FIG. 1, at least part of the first signal lines 200 extends along a first direction, at least part of the second signal lines 300 extends along a second direction, and the first direction intersects with the second direction. FIG. 1 illustratively shows that the first direction is the X direction and the second direction is the Y direction, but it is not limited thereto, and the first direction and the second direction can be interchanged. For example, the first direction and the second direction can be perpendicular to each other, but it is not limited thereto, and the included angle between the first direction and the second direction can be in the range of 60-110 degrees. For example, one of the first direction and the second direction can be a row direction, and the other of the first direction and the second direction can be a column direction. For example, each first signal line 200 extends along the first direction, and each second signal line 300 extends along the second direction. In the embodiment of the present disclosure, the extension of the first signal line along the first direction can refer to that the overall extension direction of the first signal line is the first direction, and the first signal line can be a straight line extending along the first direction or a broken line extending along the first direction. The extension of the second signal line along the second direction can refer to that the overall extension direction of the second signal line is the second direction, and the second signal line can be a straight line extending along the second direction or a broken line extending along the second direction.

As shown in FIG. 1, the plurality of first signal lines 200 include part of first signal lines 200 whose extension lines pass through the second region 102, each first signal line 200 of the part of first signal lines 200 includes a first sub-signal line 210 and a second sub-signal line 220 located on both sides of the second region 102, the first sub-signal line 210 and the second sub-signal line 220 are electrically connected through a first connection line 410 extending in the first direction and a second connection line 420 extending in the second direction, and the part of first signal lines 200 are electrically connected with a plurality of first connection lines 410 and a plurality of second connection lines 420. For example, the first connection line 410 is electrically connected with the second connection line 420, and the first signal line 200 whose extension line passes through the second region 102 will be disconnected at the position of the second region 102 to form two portions, namely the first sub-signal line 210 and the second sub-signal line 220; these two portions transmit the same signal, and these two portions are electrically connected through the first connection line 410 and the second connection line 420.

For example, the embodiment of the present disclosure is not limited to the case in which all the first connection lines are located in the same layer and all the second connection lines are located in the same layer. For example, part of second connection lines may be located in the same layer as the first connection lines, and part of second connection lines may be located in a different layer from the first connection lines.

As shown in FIG. 1, the plurality of second signal lines 300 include part of second signal lines 300 whose extension lines pass through the second region 102, each second signal line 300 of the part of second signal lines 300 includes a third sub-signal line 310 and a fourth sub-signal line 320 located on both sides of the second region 102, the third sub-signal line 310 and the fourth sub-signal line 320 are electrically connected through a third connection line 430 extending in the first direction and a fourth connection line 440 extending in the second direction, and the part of second signal lines 300 are electrically connected with a plurality of third connection lines 430 and a plurality of fourth connection lines 440. For example, the third connection line 430 is electrically connected with the fourth connection line 440, and the second signal line 300 whose extension line passes through the second region 102 will be disconnected at the position of the second region 102 to form two portions, namely the third sub-signal line 310 and the fourth sub-signal line 320; these two portions transmit the same signal, and these two portions are electrically connected through the fourth connection line 440 and the third connection line 430.

For example, the extension lines of part of first signal lines 200 passing through the second region 102 can refer to a portion of the first signal line 200 extending from the endpoint of the first signal line 200 close to the second region 102 toward the second region 102. For example, the extension lines of part of second signal lines 300 passing through the second region 102 can refer to a portion of the second signal lines 300 extending from the endpoint of the second signal line 300 close to the second region 102 toward the second region 102.

For example, the embodiment of the present disclosure is not limited to the case in which all the third connection lines are located in the same layer and all the fourth connection lines are located in the same layer. For example, part of fourth connection lines may be located in the same layer as the third connection lines, and part of fourth connection lines may be located in a different layer from the third connection lines.

For example, as shown in FIG. 1, the first signal line 200 whose extension line does not pass through the second region 102 can be a continuous signal line, and the second signal line 300 whose extension line does not pass through the second region 102 can be a continuous signal line.

As shown in FIG. 1, in a direction perpendicular to the base substrate 100, at least one second connection line 420 overlaps with at least one third connection line 430, and on the same side of the second region 102, at least one first connection line 410 is located on one side of at least one third connection line 430 away from the second region 101.

In the display substrate provided by the embodiment of the present disclosure, the second signal lines located on both sides of the second region are connected by using the third connection line and the fourth connection line, while the first signal lines located on both sides of the second region are connected by using the first connection line and the second connection line; and the second connection line overlaps with the third connection line, while at least one first connection line is located on one side of at least one third connection line away from the second region, so that the wiring space around the second region can be reduced to increase the space of the display region, and the load sudden change of the first signal line and the second signal line can be reduced, so as to prevent uneven display, such as display mura.

Compared with the design of a common display substrate in which at least one of the first signal line and the second signal line is wound around the boundary of the second region at the periphery of the second region, in the display substrate provided by the embodiment of the present disclosure, two portions, located on both sides of the second region, of both the first signal line and the second signal line are electrically connected by using connection lines extending in the first direction and the second direction, such as FIP (Fan-out In Pixel, fan-out line is located in the pixel region), so that the boundary size around the second region can be saved, and for example, the bezel around the second region is reduced, which is helpful to increase the area of the display region and further improve the display effect.

For example, as shown in FIG. 1, in the first region 101 of the display substrate, a length of the first signal line 200 whose extension line does not pass through the second region 102 is greater than a length of the second signal line 300 whose extension line does not pass through the second region 102.

For example, as shown in FIG. 1, a ratio of a size of the first signal line 200 whose extension line does not pass through the second region 102 in the first direction to a maximum size of the second region 102 in the first direction is r1, and a ratio of a maximum size of the second signal line 300 whose extension line does not pass through the second region 102 in the second direction to a maximum size of the second region 102 in the second direction is r2, and r1 is greater than r2.

In some examples, as shown in FIG. 1, the minimum distance between the fourth connection line 440 closest to the second region 102 and the edge of the second region 102 is less than the minimum distance between the first connection line 410 closest to the second region and the edge of the second region 102.

The ratio of the size of the second region to the length of the first signal line is less than the ratio of the size of the second region to the length of the second signal line. Therefore, the length of the third connection line has greater influence on the load of the second signal line than the length of the second connection line does on the load of the first signal line. In the display substrate provided by the embodiment of the present disclosure, the fourth connection line is arranged closer to the edge of the second region than the first connection line is arranged, so that the length of the third connection line connected with the second signal line whose extension line passes through the second region can be shortened, thereby reducing the difference between the load of the second signal line whose extension line passes through the second region and the load of the second signal line whose extension line does not pass through the second region.

For example, as shown in FIG. 1, on the same side of the second region 102, a distance between the fourth connection line 440 closest to the second region 102 and a second signal line 300 closest to the second region 102 whose extension line does not pass through the second region 102 is D1, a distance between the first connection line 410 closest to the second region 102 and a first signal line 200 closest to the second region 102 whose extension line does pass through the second region 102 is D2, and D1 is less than D2.

In some examples, as shown in FIG. 1, the first signal lines 200 include a data line, and the second signal lines 300 include at least a light-emitting control signal line.

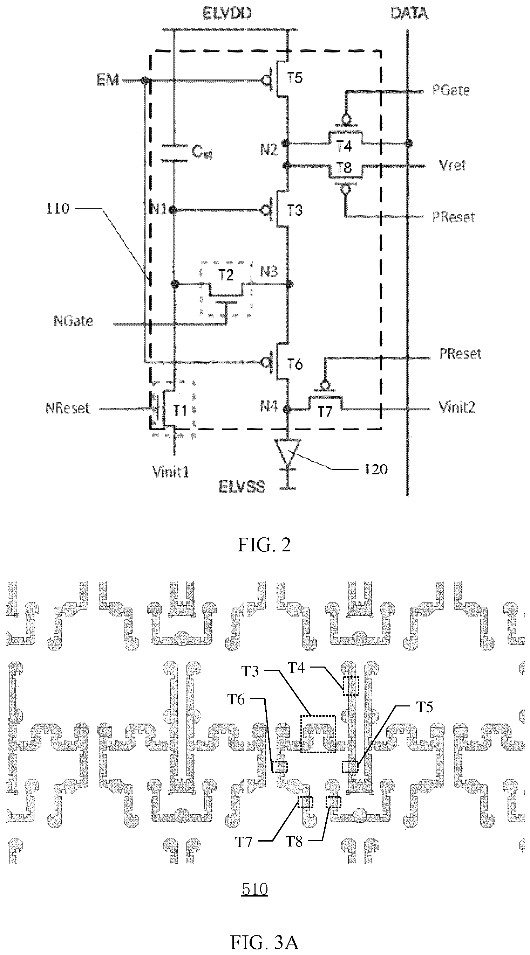

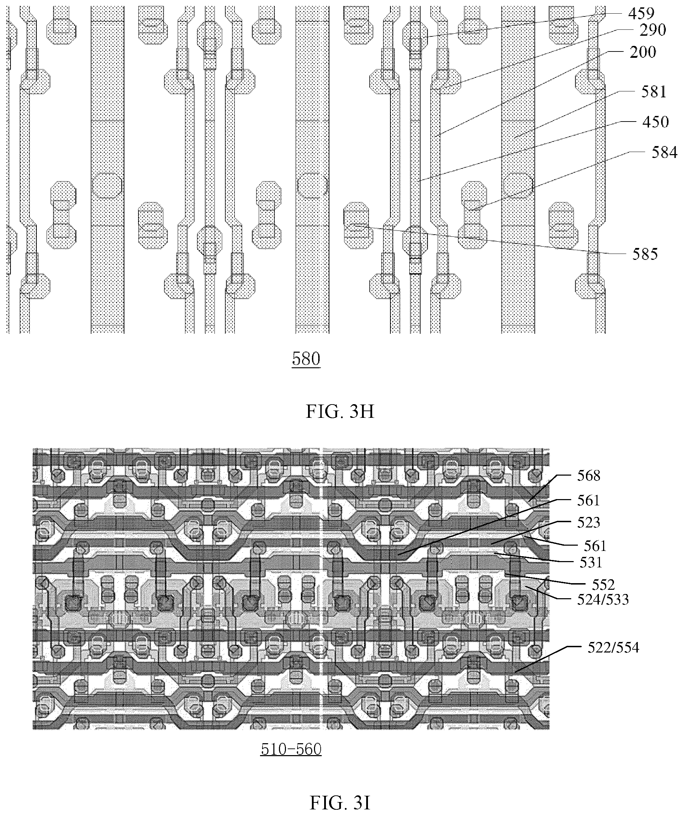

FIG. 2 is an equivalent circuit diagram of a pixel circuit according to an embodiment of the present disclosure, FIGS. 3A-3H include schematic diagrams of different film layers in a pixel circuit, and FIG. 3I is a schematic diagram of a stack of the film layers shown in FIGS. 3A-3F.

In some examples, as shown in FIG. 2, the display substrate further includes a plurality of sub-pixels, and at least part of the sub-pixels includes a light-emitting element 120 and a pixel circuit 110 electrically connected with the light-emitting element 120.

For example, as shown in FIGS. 2-3I, the pixel circuit includes a plurality of transistors and at least one capacitor. For example, the pixel circuit includes a second reset transistor T1, a threshold compensation transistor T2, a driving transistor T3, a data writing transistor T4, a second light-emitting control transistor T5, a first light-emitting control transistor T6, a first reset transistor T7, a third reset transistor T8 and a storage capacitor C.

For example, as shown in FIGS. 2-3I, the display substrate further includes reset power signal lines 561, 551 and 554, scan signal lines 552, 531 and 523, a power signal line 581, reset control signal lines 522, 532 and 553, a light-emitting control signal line 521 and a data line 200.

For example, as shown in FIGS. 2-3I, the first electrode of the threshold compensation transistor T2 is electrically connected with the first electrode of the driving transistor T3, the second electrode of the threshold compensation transistor T2 is electrically connected with the gate electrode of the driving transistor T3, and the gate electrode of the threshold compensation transistor T2 is electrically connected with the scan signal lines 531 and 552 to receive a compensation control signal; the first electrode of the first reset transistor T7 is electrically connected with the reset power signal line 561 to receive a reset signal Vinit2, the second electrode of the first reset transistor T7 is electrically connected with the first electrode of the light-emitting element (i.e. node N4), and the gate electrode of the first reset transistor T7 is electrically connected with the reset control signal line 522 to receive a reset control signal Reset(N+1); the first electrode of the third reset transistor T8 is electrically connected with the reset power signal line 551 to receive a reset signal Vref, the second electrode of the third reset transistor T8 is electrically connected with the second electrode of the driving transistor T3, and the gate electrode of the third reset transistor T8 is electrically connected with the reset control signal line 522; the first electrode of the data writing transistor T4 is electrically connected with the second electrode of the driving transistor T3, the second electrode of the data writing transistor T4 is electrically connected with the data line 200 (the first signal line 200) to receive a data signal Data, and the gate electrode of the data writing transistor T4 is electrically connected with the scan signal line 523 to receive a scan signal Gate; the first electrode of the storage capacitor C is electrically connected with the power signal line 581, and the second electrode of the storage capacitor C is electrically connected with the gate electrode of the driving transistor T3; the first electrode of the second reset transistor T1 is electrically connected with the reset power signal line 554 to receive a reset signal Vinit1, the second electrode of the second reset transistor T1 is electrically connected with the gate electrode of the driving transistor T3, and the gate electrode of the second reset transistor T1 is electrically connected with the reset control signal lines 553 and 532 to receive a reset control signal Reset(N); the gate electrode of the first light-emitting control transistor T6 is electrically connected with the light-emitting control signal line 521 to receive a light-emitting control signal EM, the first electrode of the first light-emitting control transistor T6 is electrically connected with the first electrode of the driving transistor T3, and the second electrode of the first light-emitting control transistor T6 is electrically connected with the first electrode of the light-emitting element 120; the first electrode of the second light-emitting control transistor T5 is electrically connected with the power signal line 581 to receive a first power signal VDD, the second electrode of the second light-emitting control transistor T5 is electrically connected with the second electrode of the driving transistor T3, the gate electrode of the second light-emitting control transistor T5 is electrically connected with the light-emitting control signal line 521 to receive the light-emitting control signal EM, and the second electrode of the light-emitting element 120 is electrically connected with a voltage terminal VSS (the subsequent third signal line 600). The power signal line refers to a signal line that outputs the voltage signal VDD, and can be connected with a voltage source to output a constant voltage signal, such as a positive voltage signal.

It should be noted that, in the embodiment of the present disclosure, in addition to the 8T1C (i.e., eight transistors and one capacitor) structure shown in FIG. 2, each pixel circuit can also be a structure including other numbers of transistors, such as a 7T1C structure, a 7T2C structure, a 6T1C structure, a 6T2C structure or a 9T2C structure, which is not limited in the embodiment of the present disclosure.

FIG. 3A shows a first active layer pattern 510. For example, as shown in FIG. 3A, the first active layer pattern 510 can be used to manufacture the active layers of the driving transistor T3, the data writing transistor T4, the second light-emitting control transistor T5, the first light-emitting control transistor T6, the first reset transistor T7 and the third reset transistor T8 described above, so as to form the channel regions of the above-mentioned transistors. The first active layer pattern 510 includes active region patterns (channel regions) and doped region patterns (source/drain regions) of the above-mentioned transistors of each sub-pixel, and the active region patterns and the doped region patterns of the above-mentioned transistors in the same pixel circuit are integrally arranged.

For example, the first active layer pattern 510 may include an integrally formed low temperature poly-silicon layer, and the source region and the drain region may be conductive through doping or the like, so as to achieve electrical connection between various structures. For example, the source region and the drain region can be regions doped with P-type impurities.

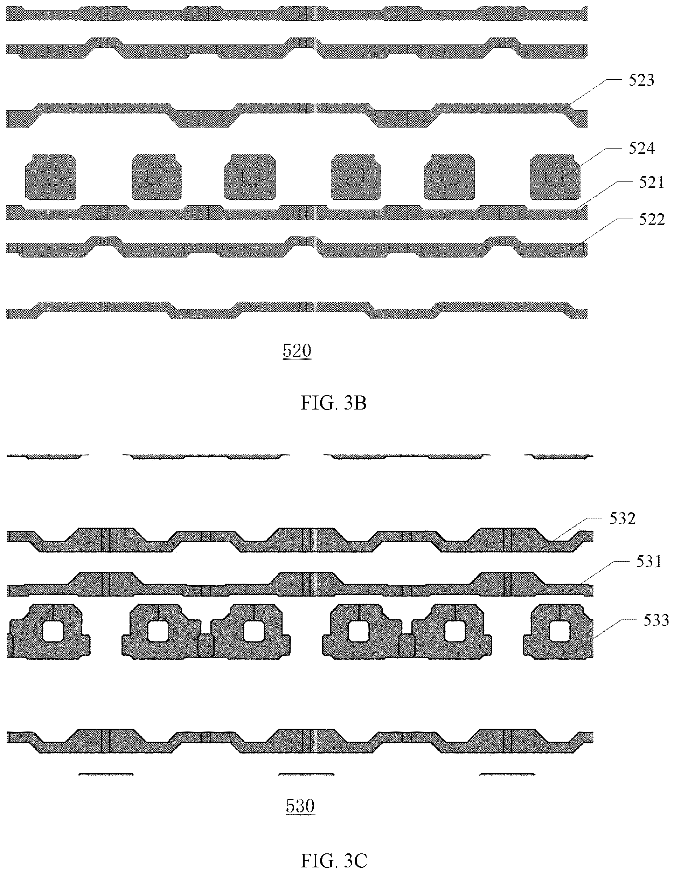

FIG. 3B shows a first conductive layer pattern 520 located on one side of the first active layer pattern 510 away from the base substrate. For example, as shown in FIG. 3B, the first conductive layer pattern 520 includes a reset control signal line 522, a scan signal line 523, a first electrode 524 of a capacitor, and the light-emitting control signal line 521. For example, the first conductive layer pattern 520 can include gate electrodes of the driving transistor T3, the data writing transistor T4, the second light-emitting control transistor T5, the first light-emitting control transistor T6, the first reset transistor T7 and the third reset transistor T8.

It should be noted that each dashed rectangular frame in FIG. 3A shows each portion of the first active layer pattern 510 overlapped with the first conductive layer pattern 520, that is, a channel region. As the channel region of each transistor, the active semiconductor layers on both sides of each channel region are conductive through processes, such as ion doping or the like, so as to serve as the first electrode and the second electrode of each transistor. The source electrode and the drain electrode of the transistor can be symmetrical in structure, so there may be no difference in physical structure between the source electrode and the drain electrode. In the embodiment of the present disclosure, in order to distinguish transistors, except for the gate electrode as the control electrode, one of the remaining electrodes is directly described as the first electrode and the other as the second electrode. Therefore, the first electrode and the second electrode of all or part of the transistors in the embodiment of the present disclosure can be interchanged as needed.

For example, as shown in FIGS. 3B and 3I, the gate electrode of the data writing transistor T4 can be a portion of the scan signal line 523 overlapped with the first active layer pattern 510; the gate electrode of the first light-emitting control transistor T6 can be a first portion of the light-emitting control signal line 521 overlapped with the first active layer pattern 510, and the gate electrode of the second light-emitting control transistor T5 can be a second portion of the light-emitting control signal line 521 overlapped with the first active layer pattern 510. The gate electrode of the third reset transistor T8 is a first portion of the reset control signal line 522 overlapped with the first active layer pattern 510, and the gate electrode of the first reset transistor T7 is a second portion of the reset control signal line 522 overlapped with the first active layer pattern 510.

FIG. 3C shows a second conductive layer pattern 530 located on one side of the first conductive layer pattern 520 away from the base substrate. For example, as shown in FIG. 3C, the second conductive layer pattern 530 includes the scan signal line 531, the second electrode 533 of the capacitor C, and the reset control signal line 532.

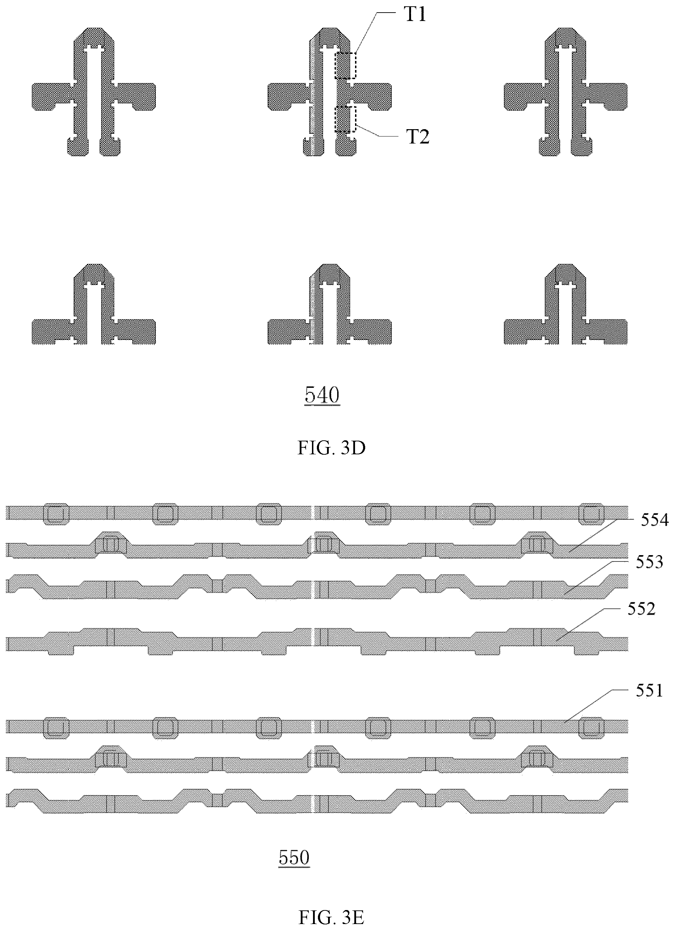

FIG. 3D shows a second active layer pattern 540 located on one side of the second conductive layer pattern 530 away from the base substrate. For example, as shown in FIG. 3D, the second active layer pattern 540 includes channel regions of the second reset transistor T1 and the threshold compensation transistor T2. For example, in the case where the active layers of the second reset transistor T1 and the threshold compensation transistor T2 are made of an oxide semiconductor, the transistors made of the oxide semiconductor have the features of good hysteresis characteristics and low leakage current, so the transistors made of the oxide semiconductor can be used instead of the transistors made of a low temperature poly-silicon material to form a low temperature polycrystalline oxide (LTPO) pixel circuit, thus achieving low leakage and improving the stability of the gate voltage of the transistors.

For example, as shown in FIGS. 3C, 3D and 3I, the gate electrode of the second reset transistor T1 can be a portion of the reset control signal line 532 overlapped with the second active layer pattern 540, and the gate electrode of the threshold compensation transistor T2 can be a portion of the scan signal line 531 overlapped with the second active layer pattern 540.

FIG. 3E shows a third conductive layer 550 located on one side of the second active layer pattern 540 away from the base substrate. For example, as shown in FIG. 3E, the third conductive layer 550 includes a reset power signal line 554, a reset control signal line 553, a scan signal line 552, and a reset power signal line 551.

For example, as shown in FIGS. 3C-3F and 3I, the reset control signal line 553 overlaps with the channel region of the second reset transistor T1, and the second reset transistor T1 includes a top gate and a bottom gate located on both sides of the active layer; the scan signal line 552 overlaps with the channel region of the threshold compensation transistor T2, and the threshold compensation transistor T2 includes a top gate and a bottom gate located on both sides of the active layer.

For example, the second reset transistor T1 and the threshold compensation transistor T2 can be N-type transistors. The driving transistor T3, the data writing transistor T4, the second light-emitting control transistor T5, the first light-emitting control transistor T6, the first reset transistor T7 and the third reset transistor T8 can be P-type transistors.

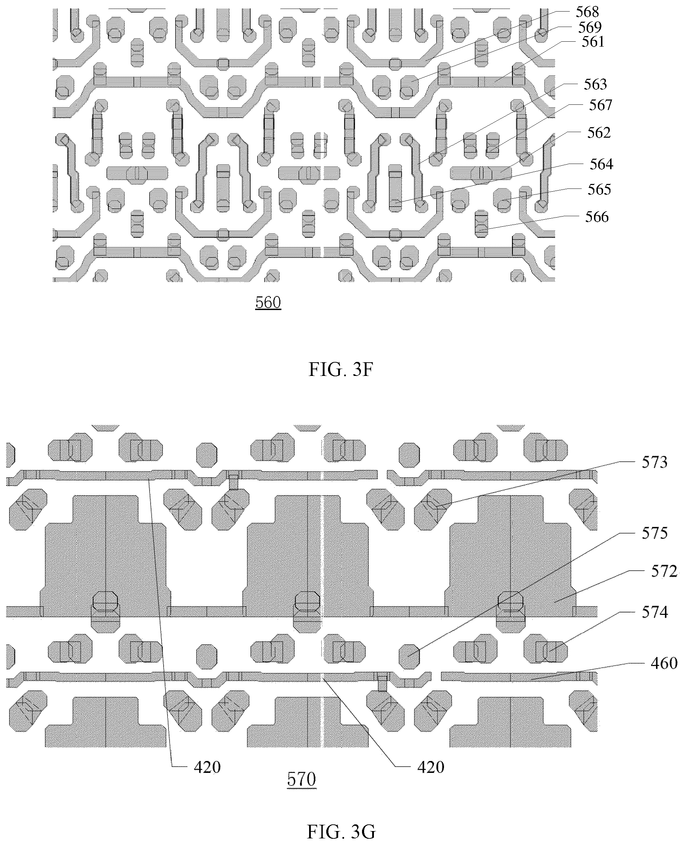

FIG. 3F shows a fourth conductive layer 560 located on one side of the third conductive layer 550 away from the base substrate. For example, as shown in FIG. 3F, the fourth conductive layer 560 includes a reset power signal line 561, a connection portion 568, a connection portion 569, a connection portion 563, a connection portion 567, a connection portion 562, a connection portion 564, a connection portion 565 and a connection portion 566.

For example, as shown in FIGS. 2-3I, both ends of the connection portion 568 are connected to the reset power signal line 551, and the middle of the connection portion 568 is connected to the first electrode of the third reset transistor T8; the connection portion 569 connects the first signal line 200 with the second electrode of the data writing transistor T4; the connection portion 563 is used to electrically connect the first electrode of the data writing transistor T4 and the second electrode of the third reset transistor T8, so as to lead the reset signal Vref to node N2; the connection portion 567 is used to electrically connect the first electrode of the driving transistor T3 and the first electrode of the threshold compensation transistor T2; the middle of the connection portion 562 is connected to the power signal line 581, and both ends of the connection portion 562 are connected to the second electrode 533 of the capacitor, so that on the one hand, the second electrodes 533 of adjacent capacitors C are electrically connected, and on the other hand, the power voltage is applied to the second electrode 533 of the capacitor C; one end of the connection portion 564 is connected to the second electrode 533 of the capacitor C, and the other end of the connection portion 564 is connected to the first electrode of the second light-emitting control transistor T5; the connection portion 565 is used to electrically connect the first electrode of the light-emitting element with the second electrode of the first light-emitting control transistor T6; the connection portion 566 is used to electrically connect the reset power signal line 554 with the first electrode of the second reset transistor T1.

FIG. 3G shows a fifth conductive layer 570 located on one side of the fourth conductive layer 560 away from the base substrate. For example, as shown in FIG. 3G, the fifth conductive layer 570 includes a connection portion 573, a connection portion 575, a power signal line 572, a connection portion 574, a second connection line 420 and a sixth connection line 460. For example, the fifth conductive layer 570 further includes a fourth connection line.

For example, as shown in FIGS. 2-3G, the connection portion 573 is electrically connected with the first signal line 200. For example, the first signal line 200 is electrically connected with the second connection line 420 through the connection portion 573, so as to transmit a first signal to the second connection line 420. For example, a connection block can be added between the connection portion 573 and the second connection line 420, so as to realize the electrical connection between the first signal line 200 and the second connection line 420. The connection portion 575 is a reserved pad, and the reserved pad can be electrically connected with the first connection line through a via. A connection block is added between the second connection line 420 and the connection portion 575 at the position where the first connection line and the second connection line need to be electrically connected, so that the first connection line can be electrically connected with the second connection line 420 through the reserved pad. Similarly, the third connection line can be electrically connected with the fourth connection line through a reserved pad. For example, the connection portion 574 is electrically connected with the connection portion 565, so as to realize the electrical connection between the second electrode of the first light-emitting control transistor T6 and the first electrode of the light-emitting element. For example, the power signal line 572 is electrically connected with the power signal line 581.

FIG. 3H shows a sixth conductive layer 580 located on one side of the fifth conductive layer 570 away from the base substrate. For example, as shown in FIG. 3H, the sixth conductive layer 580 includes a first signal line 200, a power signal line 581, a fifth connection line 450, a connection portion 584 and a connection portion 585. For example, the sixth conductive layer 580 further includes a first connection line and a third connection line.

For example, the connection portion 584 and the connection portion 585 are electrically connected with the first electrodes of different light-emitting elements.

For example, as shown in FIGS. 3G and 3H, the first signal line 200 includes a transfer pad 290, and the first signal line 200 is connected with the connection portion 573 through the transfer pad 290, so as to be electrically connected with the second connection line. For example, the fifth connection line, the first connection line and the third connection line all include a transfer pad 459, and each connection line is electrically connected with the connection portion 575 through a corresponding transfer pad 459.

For example, as shown in FIGS. 1-3H, the second signal line 300 can be located in the first conductive layer pattern 520. For example, the second signal line 300 can include at least one of a light-emitting control signal line 521 and a reset control signal line 522.

For example, as shown in FIGS. 1-3H, the plurality of second signal lines 300 are located between the plurality of first signal lines 200 and the base substrate 100, and the fourth connection line 440 is located between the plurality of first signal lines 200 and the plurality of second signal lines 300.

For example, as shown in FIG. 1, on the same side of the second region 102, all of the first connection lines 410 are located on one side of the third connection line 430 away from the second region 102. By arranging all of the first connection lines on one side of the third connection line away from the second region, it is helpful to minimize the length of the third connection line connected with all of the second signal lines whose extension lines pass through the second region, thereby reducing the load difference between the second signal lines whose extension lines pass through the second region and the second signal lines whose extension lines do not pass through the second region.

Of course, the embodiment of the present disclosure is not limited to this case, and part of the first connection lines and part of the third connection lines can be alternately arranged, which is helpful to reduce the load difference between the first signal line whose extension line passes through the second region and the first signal line whose extension line does not pass through the second region.

For example, as shown in FIG. 1, part of the second connection lines 420 are located in the same layer as each fourth connection lines 440, and among the second connection lines 420 and the fourth connection lines 440 arranged in the same layer, at least one second connection line 420 and the fourth connection line 440 is located on a same straight line and spaced apart from each other. For example, in the direction perpendicular to the base substrate 100, the second connection line 420 located on a same straight line as the fourth connection line 440 overlaps with the third connection line 430.

For example, as shown in FIG. 1, on the same side of the second region 102, at least one first signal line 200 whose extension line passes through the second region 102 is located between at least one third connection line 430 and the second region 102. For example, on the same side of the second region 102, at least one first signal line 200 whose extension line does not pass through the second region 102 is located between at least one third connection line 430 and the second region 102. For example, at least one third connection line 430 is located between at least one first signal line 200 whose extension line does not pass through the second region 102 and at least one first signal line 200 whose extension line passes through the second region 102.

In some examples, as shown in FIG. 1, on the same side of the second region 102, at least one first signal line 200 whose extension line does not pass through the second region 102 among the plurality of first signal lines is located on one side of the first connection line 410 close to the second region 102.

For example, as shown in FIG. 1, at least part of the first connection lines 410 arranged on the same side of the second region 102 is arranged at equal intervals. For example, at least part of the fourth connection lines 440 arranged on the same side of the second region 102 is arranged at equal intervals. By arranging the first connection lines at equal intervals, it is helpful to reduce the probability of a large load sudden change of the first signal line connected with the first connection line; by arranging the fourth connection lines at equal intervals, it is helpful to reduce the probability of a large load sudden change of the second signal line connected with the fourth connection line.

In some examples, as shown in FIG. 1, a ratio of a distance between one first connection line 410 and one third connection line 430 which are closest to each other among the plurality of first connection lines 410 and the plurality of third connection lines 430 to a distance between two adjacent third connection lines 430 ranges from 0.8 to 1.2. For example, the ratio of the distance between one first connection line 410 and one third connection line 430 which are closest to each other to the distance between two adjacent third connection lines 430 is ranges from 0.9 to 1.1. For example, the distance between one first connection line 410 and one third connection line 430 which are closest to each other is equal to the distance between two adjacent third connection lines 430.

By arranging one first connection line closest to the second region to be closer to the third connection line, the length of the second connection line connected with this first connection line can be made shorter, thereby reducing the difference between the load of the first signal line connected with this first connection line and the load of the first signal line closest to the second region with its extension line not passing through the second region, which is helpful to avoid the occurrence of the mura phenomenon when the display substrate is displaying.

In some examples, as shown in FIG. 1, in the first region 101, at least part of the first connection lines 410 and at least part of the third connection lines 430 are located in the same layer, and at least part of the second connection lines 420 and at least part of the fourth connection lines 440 are located in the same layer.

For example, an orthographic projection of each first connection line 410 on a straight line extending along the first direction overlaps with an orthographic projection of each third connection line 430 on the straight line extending along the first direction, and an orthographic projection of at least one second connection line 420 on a straight line extending along the second direction does not overlap with an orthographic projection of at least one fourth connection line 440 on the straight line.

In the embodiment of the present disclosure, the first connection line and the third connection line are arranged along the second direction to prevent the first connection line and the third connection line from interfering; because part of second connection lines and the fourth connection lines are arranged at intervals in the second direction, part of second connection lines can be inserted into the third connection lines, so that the part of second connection lines are electrically connected with the first signal line located on one side of the third connection line close to the second region, and the length of the second connection line can be reduced as much as possible. For example, the parasitic capacitance on the second connection line is the load difference between one first signal line, closest to the first signal line whose extension line does not pass through the second region (which can be referred to as a normal signal line) with its extension line passing through the second region, and the normal signal line, thereby reducing the difference between the load of the first signal line electrically connected with the second connection line and the normal signal line.

In some examples, as shown in FIG. 1, one second signal line 300 closest to the second region 102 among part of the plurality of second signal lines 300 whose extension lines do not pass through the second region 102 is located between one fourth connection line 440 closest to the second region 102 and another fourth connection line 440 adjacent to the one fourth connection line 440. By arranging the fourth connection line closest to the second region closer to the second signal line closest to the second region with its extension line not passing through the second region, the length of the third connection line connected with the fourth connection line closest to the second region can be reduced, thereby reducing the difference between the load of the second signal line electrically connected with the fourth connection line and the load of the second signal line whose extension line does not pass through the second region, which is helpful to reduce the display mura.

In some examples, as shown in FIG. 1, on the same side of the second region 102, a first group of connection lines 4201 among the plurality of second connection lines 420 are located on one side of at least one fourth connection line 440 close to the second region 102, and a second group of connection lines 4202 among the plurality of second connection lines 420 are located on one side of the at least one fourth connection line 440 away from the second region 102. For example, the number of second connection lines 420 included in the first group of connection lines 4201 can be less than the number of second connection lines included in the second group of connection lines 4202. For example, a plurality of fourth connection lines 440 are arranged between the first group of connection lines 4201 and the second group of connection lines 4202.

In the display apparatus provided by the embodiment of the present disclosure, the second connection lines are arranged to include two groups of connection lines located on both sides of the fourth connection line; therefore, not only the interference between the fourth connection line and the second connection line due to being arranged in the same layer can be prevented, but also the display mura caused by the load sudden change of the first signal line and the second signal line can be prevented.

In some examples, as shown in FIG. 1, in the direction perpendicular to the base substrate 100, the first group of connection lines 4201 overlap with the third connection lines 430, and the second group of connection lines 4202 do not overlap with the third connection lines 430.

For example, as shown in FIG. 1, in the direction perpendicular to the base substrate 100, at least one third connection line 430 does not overlap with the second connection line 420. For example, each connection line 420 in the first group of connection lines 4201 overlaps with at least one third connection line 430.

In some examples, as shown in FIG. 1, on the same side of the second region 102, at least one first signal line 200 connected with the second group of connection lines 4202 overlaps with each fourth connection line 440 in the direction perpendicular to the base substrate 100. For example, on the same side of the second region 102, each first signal line 200 connected with the second group of connection lines 4202 overlaps with all of the fourth connection lines 440 in the direction perpendicular to the base substrate 100.

Because the first signal line connected with the second group of connection lines overlaps with the fourth connection line, in order to avoid interference at the position between the second connection line in the second group of connection lines and the fourth connection line, in the display substrate provided by the embodiment of the present disclosure, the second group of connection lines are arranged on one side of the fourth connection line away from the second region.

For example, as shown in FIG. 1, on the same side of the center line of the second region 102 extending along the second direction, the second connection lines 420 in the first group of connection lines 4201 are arranged at equal intervals. For example, on the same side of the center line of the second region 102 extending along the second direction, the second connection lines 420 in the second group of connection lines 4202 are arranged at equal intervals. For example, a distance between two adjacent second connection lines 420 in the first group of connection lines 4201 can be equal to a distance between two adjacent second connection lines 420 in the second group of connection lines 4202.

For example, a distance between one second connection line 420 closest to a fourth connection line 440 in the second group of connection lines 4202 and the fourth connection line 440 can be equal to the distance between two adjacent second connection lines 420 in the second group of connection lines 4202.

In some examples, as shown in FIG. 1, a distance between one second connection line 420 closest to the second group of connection line 4202 in the first group of connection lines 4201 and one second connection line 420 closest to the first group of connection lines 4201 in the second group of connection lines 4202 is a first distance S1, the distance between two adjacent second connection lines 420 in the second group of connection lines 4202 is a second distance S2, and a ratio of the first distance S1 to the second distance S2 is greater than 2. For example, the ratio of the first distance S1 to the second distance S2 is greater than 3. For example, the ratio of the first distance S1 to the second distance S2 is greater than 4. For example, the ratio of the first distance S1 to the second distance S2 is greater than 5. For example, the ratio of the first distance S1 to the second distance S2 is greater than 6. For example, the ratio of the first distance S1 to the second distance S2 is greater than 7. For example, the ratio of the first distance S1 to the second distance S2 is greater than 8. For example, the ratio of the first distance S1 to the second distance S2 is greater than 9. For example, the ratio of the first distance S1 to the second distance S2 is greater than 10.

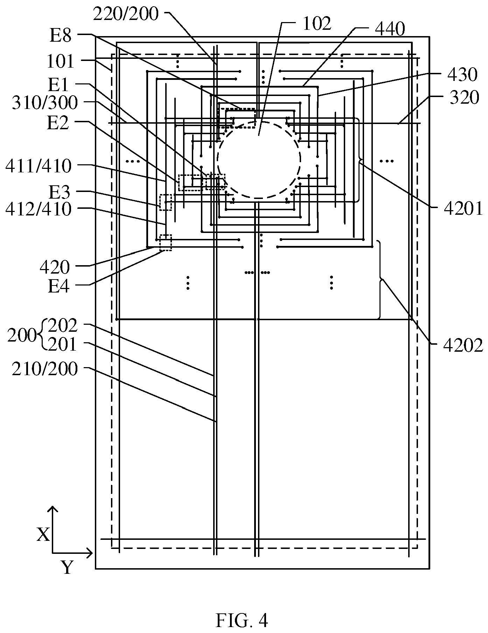

FIG. 4 is a partial planar structural view provided by another example of an embodiment of the present disclosure.

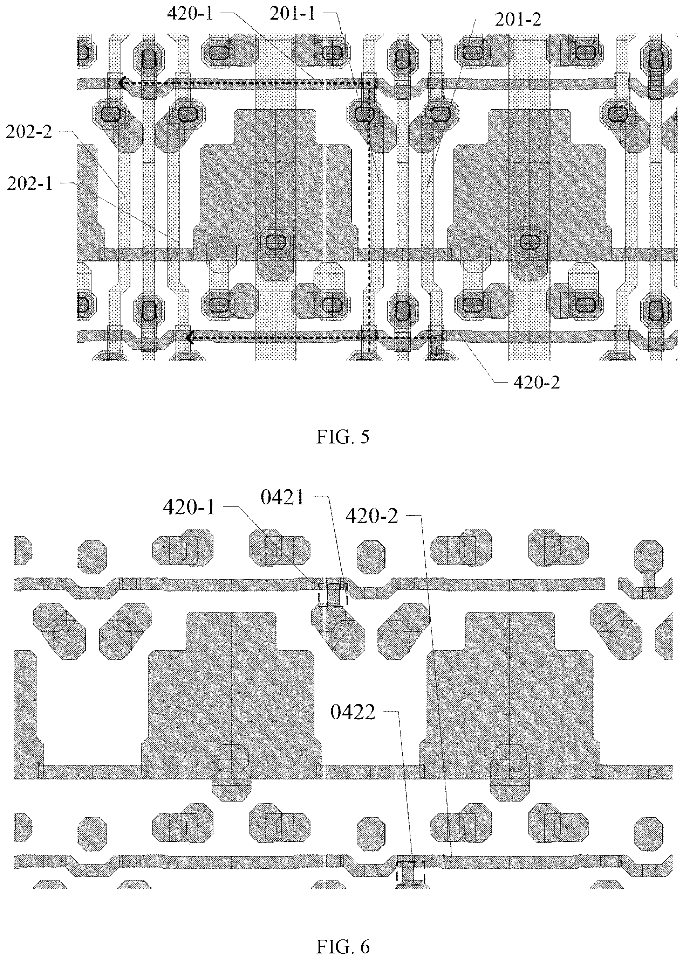

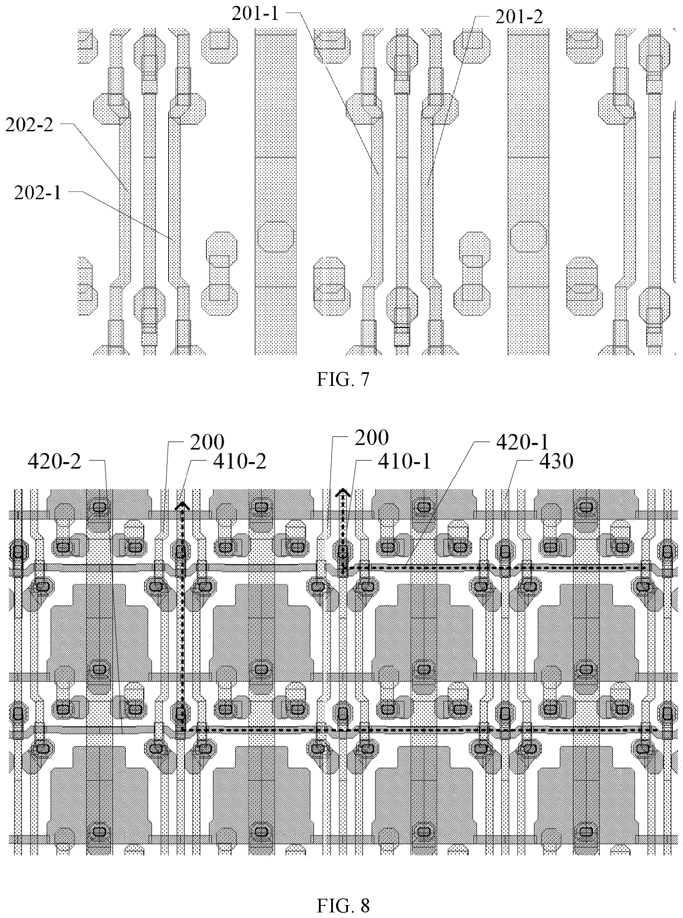

FIG. 5 is a schematic diagram of partial film layers in a region E1 shown in FIG. 4, FIGS. 6 and 7 are schematic diagrams of two conductive layers at the position shown in FIG. 5, FIG. 8 is a schematic diagram of partial film layers in a region E2 shown in FIG. 4, and FIGS. 9 and 10 are schematic diagrams of two conductive layers at the position shown in FIG. 8. The film layer structure of the regions shown in FIGS. 5-10 can have the same features as the film layer structure of the corresponding regions in the display substrate shown in FIG. 1.

For example, as shown in FIGS. 4-10, the first signal lines 200 include first signal lines 201-1 and 201-2 whose extension lines pass through the second region 102, and first signal lines 202-1 and 202-2 whose extension lines do not pass through the second region 102. The first signal line 201-1 is one first signal line closest to the first signal line whose extension line does not pass through the second region 102, with its extension line passing through the second region 102; and the first signal line 202-1 is one first signal line closest to the first signal line whose extension line passes through the second region 102, with its extension line not passing through the second region 102.

For example, as shown in FIGS. 4-10, the second connection lines 420 include a second connection line 420-2 electrically connected with the first signal line 201-2 and a second connection line 420-1 electrically connected with the first signal line 201-1. For example, the second connection line 420-1 is electrically connected with the first signal line 201-1 through a connection portion 0421, and the second connection line 420-2 is electrically connected with the first signal line 201-2 through a connection portion 0422.

For example, as shown in FIGS. 4-10, the first connection lines 410 include a first connection line 410-1 electrically connected with the second connection line 420-1 and a first connection line 410-2 electrically connected with the second connection line 420-2. For example, the second connection line 420-1 is electrically connected with the first connection line 410-1 through a connection portion 0423, and the second connection line 420-2 is electrically connected with the first connection line 410-2 through a connection portion 0425.

For example, as shown in FIGS. 4-10, the first signal line 210 (i.e., the first signal line 201-1) located on one side of the second region 102 transmits a first signal to the first signal line 220 located on the other side of the second region 102 through the second connection line 420-1 and the first connection line 410-1; the first signal line 201-2 located on one side of the second region 102 transmits a first signal to the first signal line 220 located on the other side of the second region 102 through the second connection line 420-2 and the first connection line 410-2. The black dashed arrow in FIGS. 5 and 8 illustratively shows the transmission path of the first signal.

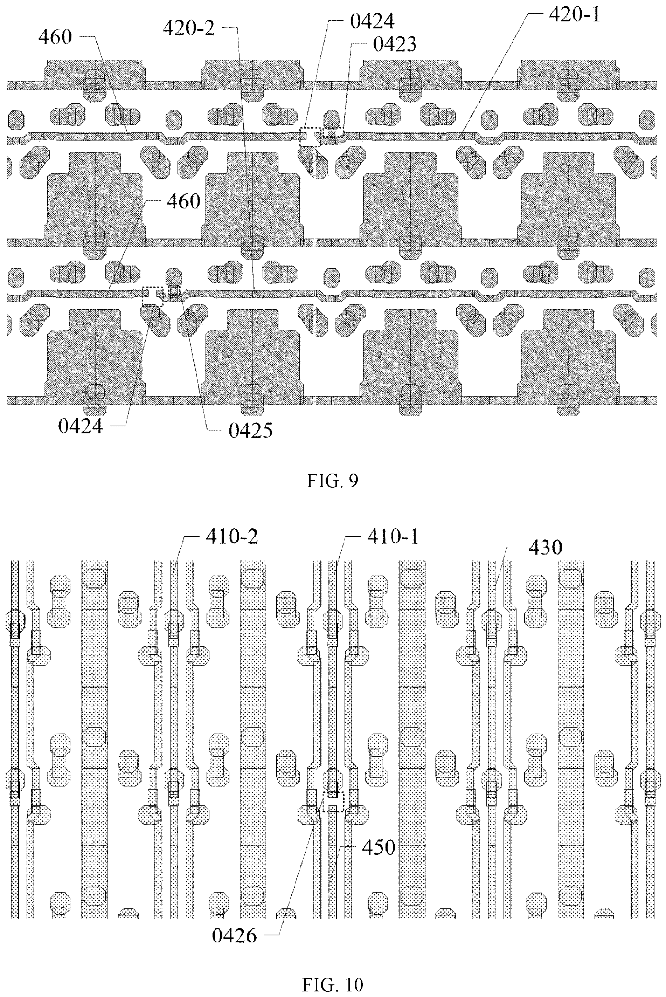

In some examples, as shown in FIGS. 9 and 10, the display substrate further includes a plurality of fifth connection lines 450 extending along the first direction and a plurality of sixth connection lines 460 extending along the second direction.

In some examples, as shown in FIGS. 9 and 10, the plurality of fifth connection lines 450 include at least part of fifth connection lines 450 located in the same layer as the first connection line 410, and a fifth connection line 450 located on the same straight line as a first connection line 410 among the at least part of fifth connection lines 450 is spaced apart from the first connection line 410. For example, an interval 0426 is arranged between the first connection line 410-1 and the fifth connection line 450.

For example, two connection lines located on the same straight line and spaced apart from each other can be two different segments of connection lines obtained by breaking the same connection line.

In some examples, as shown in FIGS. 9 and 10, the plurality of sixth connection lines 460 include at least part of sixth connection lines 460 located in the same layer as the second connection line 420, and a sixth connection line 460 located on the same straight line as a second connection line 420 among the at least part of sixth connection lines 460 is spaced apart from the second connection line 420. For example, an interval 0424 is arranged between the second connection line 420-1 and the sixth connection line 460.

In some examples, as shown in FIG. 1, the plurality of fifth connection lines 450 include at least part of fifth connection lines 450 located in the same layer as the third connection line 430, and a fifth connection line 450 located on the same straight line as a third connection line 430 among the at least part of fifth connection lines 450 is spaced apart from the third connection line 430.

In some examples, as shown in FIG. 1, the plurality of sixth connection lines 460 include at least part of sixth connection lines 460 located in the same layer as the fourth connection line 440, and a sixth connection line 460 located on the same straight line as a fourth connection line 440 among the at least part of sixth connection lines 460 is spaced apart from the fourth connection line 440.

In some examples, as shown in FIG. 1, the display substrate further includes a peripheral region 103, and the peripheral region surrounds the display region, such as the first region 101. For example, the peripheral region 103 is a region not used for display, and the display region is a region used for display. For example, the first region 101 is a region used for display.

In some examples, as shown in FIGS. 1, 17 and 18, the display substrate further includes a third signal line 600 located in the peripheral region 103, and at least one of the fifth connection line 450 and the sixth connection line 460 is electrically connected with the third signal line 600. For example, the third signal line 600 can be a ring-shaped signal line surrounding the display region. For example, the third signal line 600 is configured to transmit a VSS signal. For example, the third signal line 600 is configured to be electrically connected with the second electrode of the light-emitting element, such as the cathode.

For example, both the fifth connection line 450 and the sixth connection line 460 are electrically connected with the third signal line 600.

In the embodiment of the present disclosure, by arranging a plurality of fifth connection lines and a plurality of sixth connection lines, it is helpful to improve the uniformity of the connection line positions and reduce the display mura; in addition, by electrically connecting the fifth connection lines and the sixth connection lines with the third signal lines, it is helpful to reduce the load of the third signal line.

In some examples, as shown in FIGS. 5-10, at least one first connection line 410 and at least one third connection line 430 are located in the same layer as the plurality of first signal lines 200. For example, each first connection line 410 is arranged in the same layer as the first signal lines 200. For example, each third connection line 430 is arranged in the same layer as the first signal lines 200.

In some examples, as shown in FIGS. 5-10, at least one of an interval between the fifth connection line 450 and the first connection line 410 and an interval between the fifth connection line 450 and the third connection line 430 overlaps with the film layer where the fourth connection line 440 is located, and for example, overlaps with the structure in the fifth conductive layer 570. For example, at least one of an interval between the sixth connection line 460 and the second connection line 420 and an interval between the sixth connection line 460 and the fourth connection line 440 overlaps with the film layer where the first connection line 410 is located, and for example, overlaps with the structure in the sixth conductive layer 580.

For example, as shown in FIGS. 5-10, the interval 0424 between the second connection line 420 and the sixth connection line 460 overlaps with the first signal line 200. For example, the interval 0426 between the first connection line 410 and the fifth connection line 450 overlaps with the second connection line 420.

In the display substrate provided by the embodiment of the present disclosure, the interval between two connection lines located on the same straight line is blocked by another layer of connection lines or another layer of signal lines, which is helpful to further reduce the display mura, such as the screen-off mura.

In some examples, as shown in FIG. 8, at least one first connection line 410 is provided on both sides thereof with two first signal lines 200 immediately adjacent to this first connection line 410, and the minimum distance ratio between these two first signal lines 200 and this first connection line 410 ranges from 0.9 to 1.1. For example, the minimum distances between these two first signal lines 200 and this first connection line 410 are the same.

For example, as shown in FIG. 8, the plurality of first signal lines 200 can be divided into a plurality of first signal line pairs 200. Each first signal line pair 200 is located between two adjacent sub-pixels, for example, between two light-emitting elements. And one first connection line 410 is arranged between at least one first signal line pair 200.

In some examples, as shown in FIG. 1, at least one third connection line 430 is provided on both sides thereof with two first signal lines 200 immediately adjacent to this third connection line 430, and the minimum distance ratio between these two first signal lines 200 and this third connection line 430 ranges from 0.9 to 1.1. For example, the minimum distances between these two first signal lines 200 and this third connection line 430 are the same.

For example, one third connection line 430 is arranged between at least one first signal line pair 200.

For example, as shown in FIG. 10, at least one fifth connection line 450 is provided on both sides thereof with two first signal lines 200 immediately adjacent to this fifth connection line 450, and the minimum distance ratio between these two first signal lines 200 and this fifth connection line 450 ranges from 0.9 to 1.1. For example, the minimum distances between these two first signal lines 200 and this fifth connection line 450 are the same.

In the display substrate provided by the embodiment of the present disclosure, the first connection line and the first signal lines are arranged in a 2in1 manner, the third connection line and the first signal lines are arranged in a 2in1 manner, and the fifth connection line and the first signal lines are arranged in a 2in1 manner.

Of course, the embodiment of the present disclosure is not limited to this case, and two first connection lines may be arranged between at least one first signal line pair, for example, using a 1in1 arrangement manner.

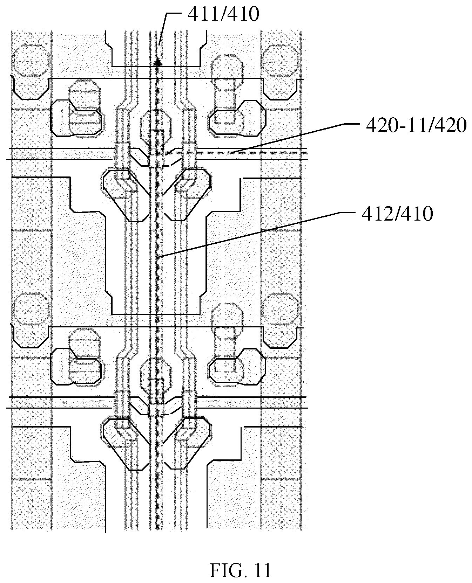

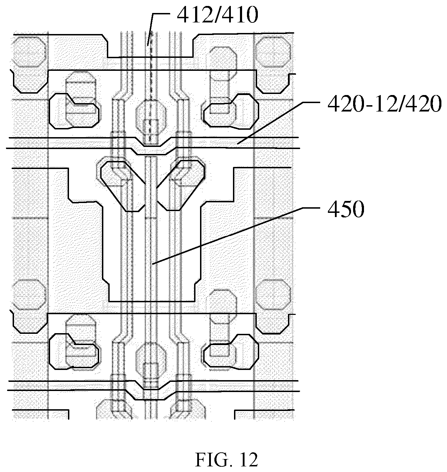

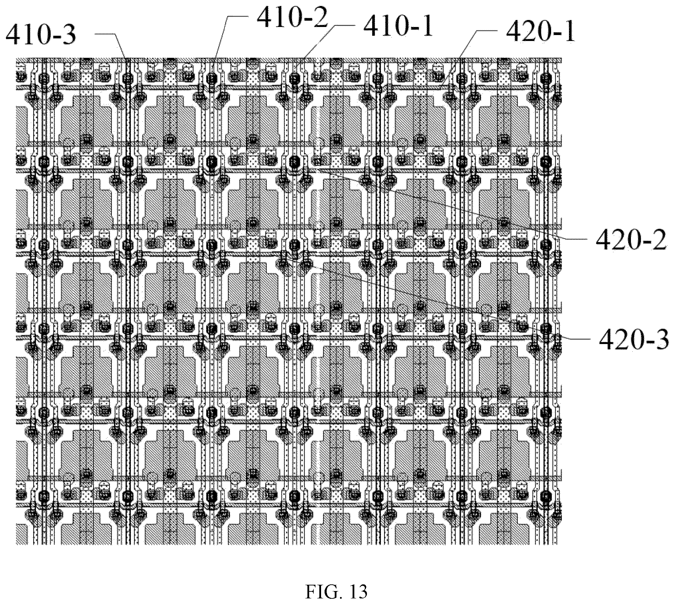

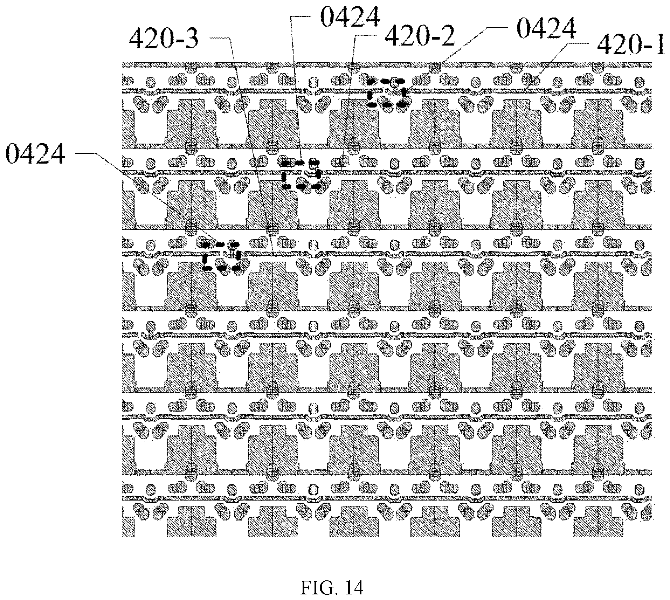

FIG. 11 is a schematic diagram of partial film layers in a region E3 shown in FIG. 4, and FIG. 12 is a schematic diagram of partial film layers in a region E4 shown in FIG. 4. FIG. 13 is a schematic diagram of partial film layer including a region E1 shown in FIG. 4, and FIGS. 14 and 15 are schematic diagrams of two conductive layers at the position shown in FIG. 13.

In some examples, as shown in FIGS. 4 and 11, the first connection line 410 connected with one second connection line 420 closest to the second group of connection lines 4202 in the first group of connection lines 4201 includes two portions 411 and 412 respectively located on both sides of the one second connection line 420 in the first direction. For example, one portion 411 of the first connection line 410 is used to transmit a first signal to the first signal line 200 located on the other side of the second region 102, and the other portion 412 of the first connection line 410 is used to balance the difference between the parasitic capacitance on the first connection line 410 and the parasitic capacitance on one second connection line 420 closest to the first group of connection lines 4201 in the second group of connection lines 4202, and for example, the other portion 412 can be used as a load compensation portion. For example, one portion 411 of the first connection line 410 can be regarded as a forward extended portion, and the other portion 412 of the first connection line 410 can be regarded as a reversely extended portion.

In the case where the distance between two second connection lines, which are respectively located in the first group of connection lines and the second group of connection lines and are closest to each other, is greater than the distance between two adjacent second connection lines in the first group of connection lines (or the second group of connection lines), the first connection line connected with a second connection line closest to the second group of connection lines in the first group of connection lines is lengthened, and for example, the first connection line includes a forward extended portion for transmitting the first signal line and another portion reversely extended relative to the forward extended portion, so that the load sudden change of the second connection lines in these two groups of connection lines can be reduced, thereby reducing the display mura and improving the display effect.

In some examples, as shown in FIGS. 4, 11 and 12, the first connection line 410 connected with one second connection line 420-11 closest to the second group of connection lines 4202 in the first group of connection lines 4201 extends to a position of one second connection line 420-12 closest to the first group of connection lines 4201 in the second group of connection lines 4202. For example, the reversely extended portion 412 of the first connection line 410 connected with the second connection line 420-11 extends to the position of the second connection line 420-12.

In the embodiment of the present disclosure, the reversely extended portion of the first connection line connected with one second connection line closest to the second group of connection lines in the first group of connection lines extends to the position of a second connection line closest to the first group of connection lines in the second group of connection lines, which is helpful to minimize the load difference between the two second connection lines which are respectively located in the first group of connection lines and the second group of connection lines and are closest to each other, and further prevent the occurrence of a large load jump due to a large interval between the two group of connection lines.

For example, as shown in FIGS. 4, 11 and 12, the interval between the reversely extended portion 412 of the first connection line 410 connected with the second connection line 420-11 and the fifth connection line 450 overlaps with the second connection line 420-12.

In some examples, as shown in FIGS. 4 and 11-15, each first connection line 410 among N first connection lines 410 respectively connected with N second connection lines 420 closest to the second group of connection lines 4202 in the first group of connection lines 4201 includes two portions 411 and 412 respectively located on both sides of a second connection line 420 connected with the each first connection line in the first direction; and along a direction approaching the second region 102, the lengths of the two portions 411 and 412 of the N first connection lines 410 located on both sides of the second connection line 420 connected with the N first connection lines 410 in the first direction are gradually reduced, where N is a positive integer greater than or equal to 1, and the number of second connection lines 420 in the first group of connection lines 4101 located on one side of the center of the second region 102 is greater than or equal to N.

For example, as shown in FIGS. 4 and 13-15, the second connection lines 420 closest to the second group of connection lines 4202 in the first group of connection lines 4201 include a second connection line 420-1, a second connection line 420-2 and a second connection line 420-3, and the first connection lines 410 include a first connection line 410-1 connected with the second connection line 420-1, a first connection line 410-2 connected with the second connection line 420-2, and a first connection line 410-3 connected with the second connection line 420-3.

For example, as shown in FIGS. 4 and 13-15, along a direction pointing from the second group of connection lines 4202 to the first group of connection lines 4201, the second connection line 420-3, the second connection line 420-2 and the second connection line 420-1 are arranged in sequence, and for example, the second connection line 420-3 is closer to the second group of connection lines 4202 than the second connection line 420-2 is.

For example, as shown in FIGS. 4 and 13-15, the lengths of the portion 412-3 of the first connection line 410-3, the portion 412-2 of the first connection line 410-2 and the portion 412-1 of the first connection line 410-1 are gradually reduced, and for example, the length of the portion 412-3 of the first connection line 410-3 is greater than the length of the portion 412-2 of the first connection line 410-2.

In the display substrate provided by the embodiment of the present disclosure, according to the distance relationship between each second connection line in the first group of connection lines and the second group of connection lines, the length of the reversely extended portion of the first connection line is adjusted, which is helpful to reduce the load difference between adjacent second connection lines in the first group of connection lines as much as possible while reducing the load sudden change of the second connection line in the second group of connection lines and the second connection line in the first group of connection lines.

For example, as shown in FIGS. 4 and 13-15, the length difference between the reversely extended portions of any two adjacent first connection lines 410 among a plurality of first connection lines 410 connected with at least part of second connection lines 420 in the first group of connection lines 4201 is within a certain range; for example, the length difference can be the size of 1~5 sub-pixels in the first direction; for example, the length difference can be the size of 2~4 sub-pixels in the first direction.

For example, as shown in FIG. 4, the first connection line 410 connected with the second connection line 420 in the first group of connection lines 4201 can include two reversely extended portions 412 and a forward extended portion 411 located between the two reversely extended portions 412. For example, two reversely extended portions 412 included in each first connection line 410 have the same length.

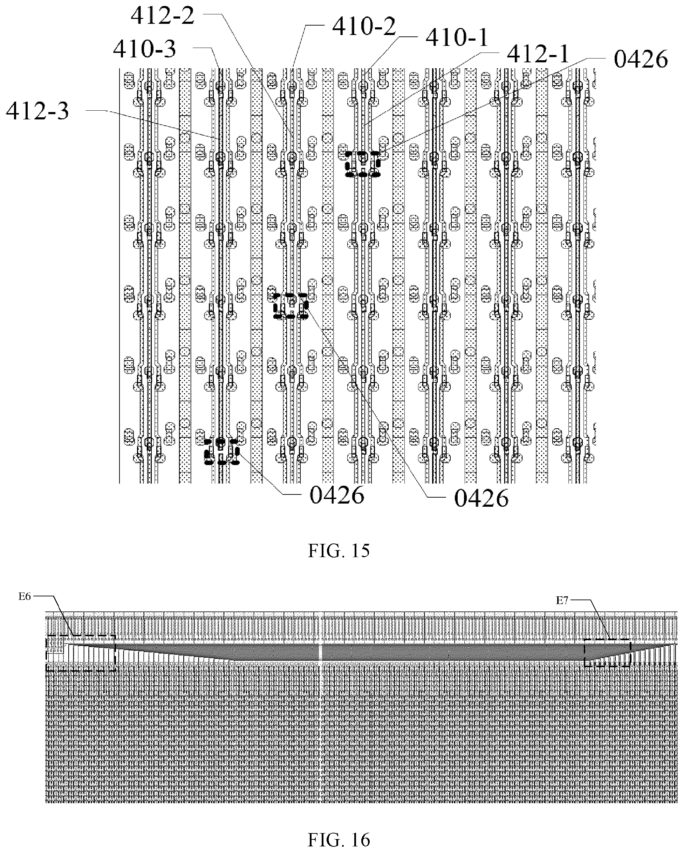

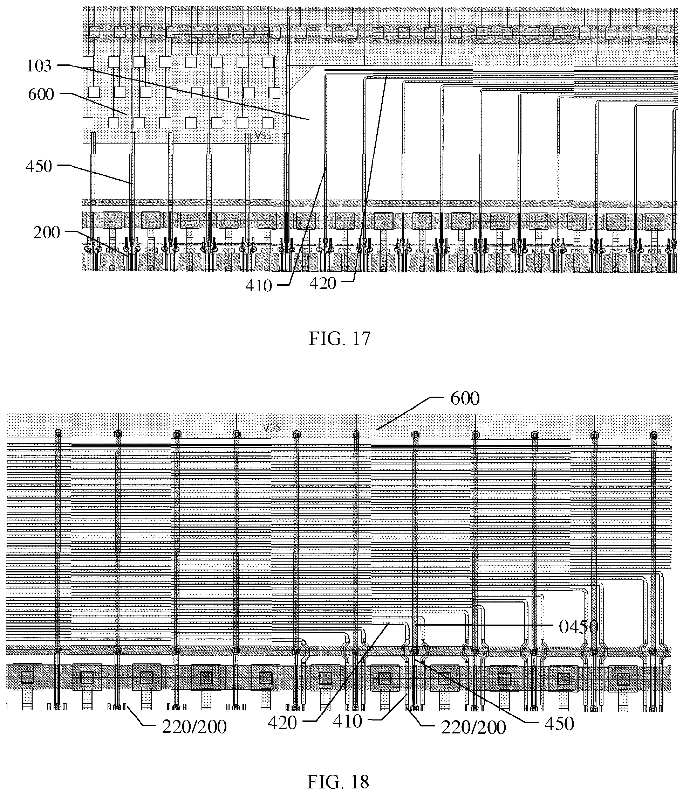

FIG. 16 is a schematic diagram of partial film layers in a region E5 shown in FIG. 1, FIG. 17 is a schematic diagram of partial film layers in a region E6 shown in FIG. 16, and FIG. 18 is a schematic diagram of partial film layers in a region E7 shown in FIG. 16.

In some examples, as shown in FIGS. 1, 11, 12 and 16-18, the plurality of second connection lines 4202 include a second connection line 420 located in the first region 101 and a second connection line 420 located in the peripheral region 103, the second connection line 420 located in the first region 101 is arranged in a different layer from the first connection line 410, and the second connection line 420 located in the peripheral region103 is arranged in the same layer as the first connection line 410.

For example, as shown in FIGS. 1 and 16-18, one first connection line 410 is electrically connected with two second connection lines 420. One second connection line 420, located in the first region 101, of these two second connection lines 420 is arranged in a different layer from the first connection line 410, and the other second connection line 420, located in the peripheral region 103, of these two second connection lines 420 is arranged in the same layer as and integrated with the first connection line 410.

In some examples, as shown in FIGS. 1 and 16-18, the second connection line 420 located in the peripheral region 103 is arranged in the same layer as the first signal line 200. For example, the second sub-signal line 220 located in a side of the second region 102 close to the peripheral region 103 is arranged in the same layer as and integrated with the second connection line 420 connected with the second sub-signal line 220.

For example, FIGS. 17 and 18 illustratively show that the fifth connection line 450 is electrically connected with the third signal line 600 located in the peripheral region 103. For example, the fifth connection line 450 in the region E6 is directly electrically connected with the third signal line 600, and the fifth connection line 450 in the region E7 is electrically connected with the third signal line 600 through a transfer line 0450 arranged in the same layer as the second connection line in the first region 101.

For example, as shown in FIG. 1, both the third connection line 430 and the fourth connection line 440 are located in the first region 101.

For example, as shown in FIG. 1, each second connection line 420 included in the first group of connection lines 4201 and the first connection lines 410 connected with respective second connection lines 420 in the first group of connection lines 4201 are located in the first region 101.

For example, the display substrate further includes: a plurality of first light-emitting elements, a plurality of first pixel circuits and a plurality of second pixel circuits located in the first region 101, and a plurality of second light-emitting elements located in the second region 102; the plurality of first pixel circuits are electrically connected with the plurality of first light-emitting elements in one-to-one correspondence, and the plurality of second pixel circuits are electrically connected with the second the plurality of light-emitting elements in one-to-one correspondence. For example, the second region 102 can be a region used for disposing a camera, and the second pixel circuit for driving the second light-emitting element in the second region 102 to emit light is located in the first region 101, so that the light transmittance of the second region 102 can be improved. That is, the light transmittance of the second region 102 is increased by separately disposing the light-emitting element and the pixel circuit.

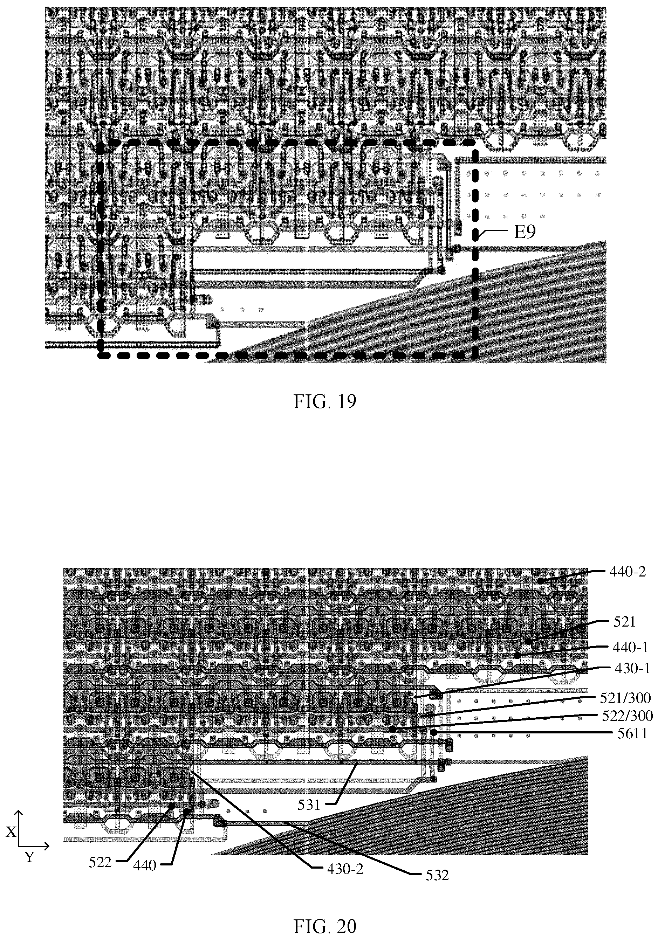

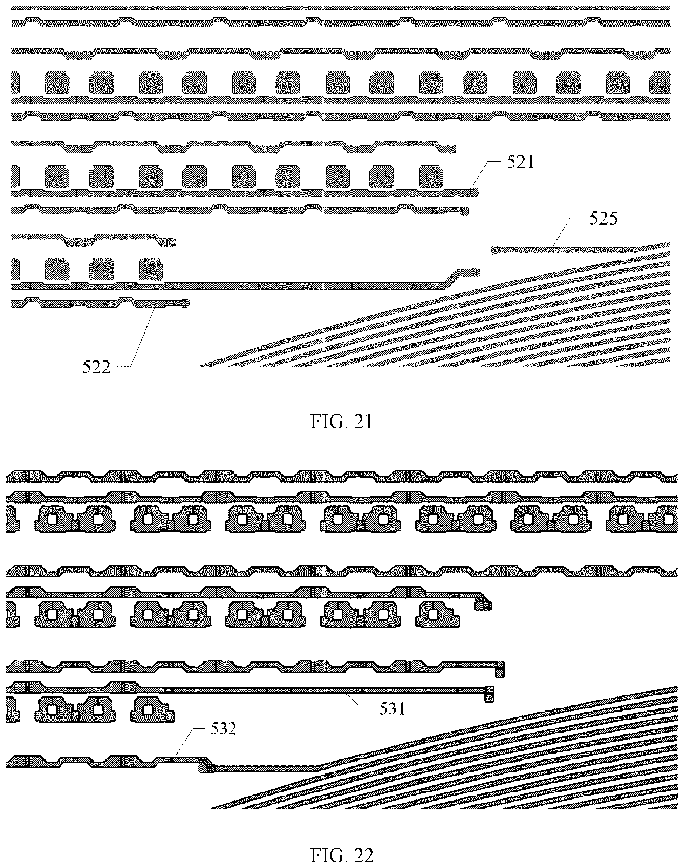

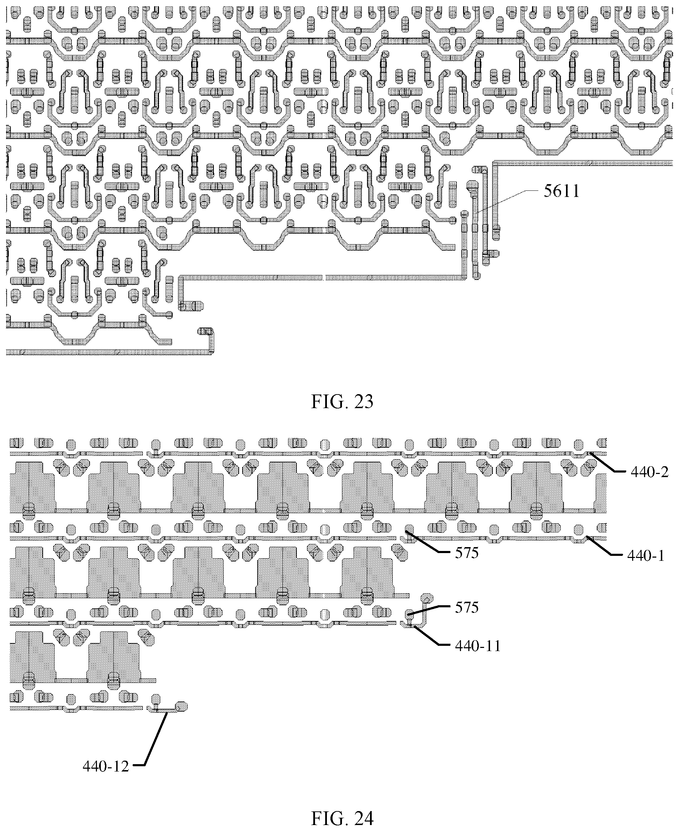

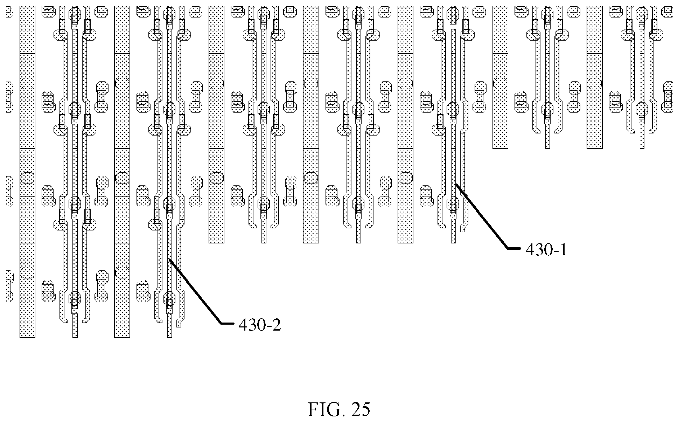

FIG. 19 is a schematic diagram of a partial structure of a region E8 shown in FIG. 4, FIG. 20 is a schematic diagram of a partial structure of a region E9 shown in FIG. 19, and FIGS. 21-25 are schematic diagrams of different film layers at the position shown in FIG. 20. The region E9 is a small region in the region E8.

For example, as shown in FIGS. 2-4 and 19-25, the second signal lines 300 include light-emitting control signal lines 521. For example, the light-emitting control signal lines 521 adopt a unilateral driving mode.

For example, as shown in FIGS. 2-4 and 19-25, the light-emitting control signal line 521 is electrically connected with the fourth connection line 440-11 in the fifth conductive layer 570 through a transfer line 5611, the fourth connection line 440-11 is electrically connected with the third connection line 430-1 in the sixth conductive layer 580 through a connection portion 575, and the third connection line 430-1 is electrically connected with the fourth connection line 440-1 through a connection portion 575. Thus, the third sub-signal line 310 (light-emitting control signal line 521) located on the left side of the second region 102 (the direction opposite to the Y-direction arrow shown in the figure is leftward) is electrically connected with the fourth sub-signal line 320 (light-emitting control signal line 521) located on the right side of the second region 102.

For example, as shown in FIGS. 2-4 and 19-25, a light-emitting control signal line 521 closest to the second region 102 among part of the plurality of light-emitting control signal lines 521 whose extension lines do not pass through the second region 102 is located between one fourth connection line 440-1 closest to the second region 102 and a fourth connection line 440-2 adjacent to the one fourth connection line 440-1.

For example, as shown in FIGS. 2-4 and 19-25, the second signal lines 300 include reset control signal lines 522. For example, the reset control signal lines 522 adopt a unilateral driving mode.

For example, as shown in FIGS. 2-4 and 19-25, the reset control signal line 522 is electrically connected with the fourth connection line 440-12 in the fifth conductive layer 570 through a transfer line in the fourth conductive layer 560, the fourth connection line 440-12 is electrically connected with the third connection line 430-2 in the sixth conductive layer 580 through a connection portion 575, and the third connection line 430-2 is electrically connected with the fourth connection line 440-2 through a connection portion 575. Thus, the third sub-signal line 310 (reset control signal line 522) located on the left side of the second region 102 is electrically connected with the fourth sub-signal line 320 (reset control signal line 522) located on the right side of the second region 102.

In the display substrate provided by the embodiment of the present disclosure, the process of writing signals through the light-emitting control transistor is less affected by parasitic capacitance, and the signals of the reset transistor T7 and the reset transistor T8 are also less affected by parasitic capacitance; at least one of the light-emitting control signal line and the reset control signal line connected with the reset transistor T7 and the reset transistor T8 is arranged to realize the electrical connection of two portions located on both sides of the second region by using a connection line extending along the first direction and a connection line extending along the second direction, which is helpful to reduce the wiring space around the second region to increase the area of the display region while minimizing the impact on the working performance of the pixel circuit.

For example, the scan signal lines 523 adopt a bilateral driving mode, so the scan signal lines 523 located on both sides of the second region can be disconnected.

For example, as shown in FIGS. 2-4 and 19-25, the scan signal line 531 electrically connected with the threshold compensation transistor T2 adopts a unilateral driving mode. For example, the scan signal line 531 located on one side of the second region 102 is electrically connected with the scan signal line 531 located on the other side of the second region 102 through a connection line 525 in the first conductive layer 520 and/or a connection line in the fourth conductive layer 560.

In the display substrate provided by the embodiment of the present disclosure, the scan signal line electrically connected with the threshold compensation transistor T2 does not realize the electrical connection between the two portions located on both sides of the second region by using a connection line extending in the first direction and a connection line extending in the second direction, but realizes the electrical connection between the two portions located on both sides of the second region by winding around the edge of the second region, so that the parasitic capacitance generated on the scan signal line electrically connected with the threshold compensation transistor T2 can be lower.

For example, as shown in FIGS. 2-4 and 19-25, the reset control signal line 532 electrically connected with the second reset transistor T1 adopts a unilateral driving mode. For example, the reset control signal line 532 located on one side of the second region 102 is electrically connected with the reset control signal line 532 located on the other side of the second region 102 through a connection line in the fourth conductive layer 560, or the reset control signal line 532 located on one side of the second region 102 is directly wound at the edge of the second region 102 to the other side of the second region 102.

In the display substrate provided by the embodiment of the present disclosure, the reset control signal line electrically connected with the second reset transistor T1 does not realize the electrical connection between the two portions located on both sides of the second region by using a connection line extending in the first direction and a connection line extending in the second direction, but realizes the electrical connection between the two portions located on both sides of the second region by winding around the edge of the second region, so that the parasitic capacitance generated on the reset control signal line electrically connected with the second reset transistor T1 can be lower.

In the pixel circuit provided by the embodiment of the present disclosure, the first light-emitting control transistor and the second light-emitting control transistor electrically connected with the light-emitting control signal line, and the first reset transistor and the third reset transistor electrically connected with the reset control signal line are all P-type transistors, and the threshold compensation transistor and the second reset transistor are N-type transistors. Because the voltage jump of the gate signal of the P-type transistor has less influence than the voltage jump of the gate signal of the N-type transistor, it is preferred that all or part of the gate control lines corresponding to the P-type transistors can realize the electrical connection between the two portions located on both sides of the second region by using a connection line extending in the first direction and a connection line extending in the second direction (i.e., FIP connection method), thereby reducing the area of the non-display region around the second region to achieve a narrow bezel; at the same time, the control signal lines electrically connected with the gate electrodes of the threshold compensation transistor and the second reset transistor which are N-type transistors adopt the above winding manner.

Of course, the embodiment of the present disclosure is not limited to this case. In the case where all transistors in the pixel circuit are low temperature poly-silicon (LTPS) transistors, for example, in the case where all transistors are P-type transistors, part or all of the gate control signal lines electrically connected with the gate electrodes of all P-type transistors can realize the electrical connection between the two portions located on both sides of the second region by using a connection line extending in the first direction and a connection line extending in the second direction (i.e., FIP connection method), thereby reducing the area of the non-display region to achieve a narrow bezel.

Optionally, according to the embodiment of the present disclosure, the display substrate further includes a light-emitting element and a pixel circuit located on the base substrate, and the pixel circuit is electrically connected with the light-emitting element; the pixel circuit includes at least one N-type thin film transistor and at least one P-type thin film transistor; the second signal lines include a signal line connected with the gate electrode of the at least one P-type thin film transistor.

Optionally, according to the embodiment of the present disclosure, the display substrate further includes a light-emitting element and a pixel circuit located on the base substrate, and the pixel circuit is electrically connected with the light-emitting element; the pixel circuit includes at least one oxide thin film transistor and at least one low temperature poly-silicon thin film transistor; the second signal lines include a signal line connected with the gate electrode of the at least one low temperature poly-silicon thin film transistor.

Another embodiment of the present disclosure provides a display apparatus, which includes any of the above display substrates.

For example, the display apparatus can be a QHD (Quad High Definition) display apparatus, and QHD refers to four times the resolution of a full high definition screen. For example, the display apparatus can be an FHD (Full High Definition) display apparatus, and FHD refers to full high definition.

For example, the display apparatus provided by the embodiment of the present disclosure can be an organic light-emitting diode display apparatus, such as an active-matrix organic light-emitting diode (AMOLED) display apparatus.

For example, the display apparatus can further include a cover plate located on the display side of the display substrate. For example, the display apparatus can further include a functional component located on one side of the base substrate away from the light-emitting element, and the functional component is directly opposite to the second region. For example, the functional component includes at least one of a camera module (e.g., a front camera module), a 3D structured light module (e.g., a 3D structured light sensor), a time-of-flight 3D imaging module (e.g., a time-of-flight sensor), an infrared sensing module (e.g., an infrared sensor), etc.

In the display apparatus provided by the embodiment of the present disclosure, the signal lines located on both sides of the second region are electrically connected by using the first connection line, the second connection line, the third connection line and the fourth connection line, and the second connection line overlaps with the third connection line, while the first connection line is located on one side of the third connection line away from the second region, so that the wiring space around the second region can be reduced to increase the area of the display region, and the load sudden change of the first signal line and the second signal line can be reduced.

For example, the display apparatus can include any product or component having display function, such as a mobile phone, a tablet computer, a notebook computer, a navigator, etc., without being limited in the embodiment of the present disclosure.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate (100), comprising a first region (101) and a second region (102), the first region (101) being located at a periphery of the second region (102);
a plurality of first signal lines (200), located on the base substrate (100), and not passing through the second region (102);
a plurality of second signal lines (300), located in a different layer from the plurality of first signal lines (200), and not passing through the second region (102),
wherein at least part of the plurality of first signal lines (200) extends along a first direction, at least part of the plurality of second signal lines (300) extends along a second direction, and the first direction intersects with the second direction;
the plurality of first signal lines (200) comprise part of first signal lines (200) whose extension lines pass through the second region (102), each first signal line (200) of the part of first signal lines (200) comprises a first sub-signal line (210) and a second sub-signal line (220) located on both sides of the second region (102), the first sub-signal line (210) and the second sub-signal line (220) are electrically connected through a first connection line (410) extending in the first direction and a second connection line (420) extending in the second direction, and the part of first signal lines (200) are electrically connected with a plurality of first connection lines (410) and a plurality of second connection lines (420);
the plurality of second signal lines (300) comprise part of second signal lines (300) whose extension lines pass through the second region (102), each second signal line (300) of the part of second signal lines (300) comprises a third sub-signal line (310) and a fourth sub-signal line (320) located on both sides of the second region (102), the third sub-signal line (310) and the fourth sub-signal line (320) are electrically connected through a third connection line (430) extending in the first direction and a fourth connection line (440) extending in the second direction, and the part of second signal lines (300) are electrically connected with a plurality of third connection lines (430) and a plurality of fourth connection lines (440);
in a direction perpendicular to the base substrate (100), at least one second connection line (420) overlaps with at least one third connection line (430), and on a same side of the second region (102), at least one first connection line (410) is located on one side of at least one third connection line (430) away from the second region (102).

2. The display substrate according to claim 1, wherein the plurality of first signal lines (200) comprise a data line, and the plurality of second signal lines (300) at least comprise a light-emitting control signal line;
optionally, a minimum distance between one fourth connection line (440) closest to the second region (102) and an edge of the second region (102) is less than a minimum distance between one first connection line (410) closest to the second region (102) and an edge of the second region (102).

3. The display substrate according to any one of claims 1-2, wherein, on a same side of the second region (102), a first group of connection lines (4201) among the plurality of second connection lines (420) are located on one side of at least one fourth connection line (440) close to the second region (102), and a second group of connection lines (4202) among the plurality of second connection lines (420) are located on one side of the at least one fourth connection line (440) away from the second region (102).

4. The display substrate according to claim 3, wherein, in the direction perpendicular to the base substrate (100), the first group of connection lines (4201) overlap with the third connection line (430), and the second group of connection lines (4202) do not overlap with the third connection line (430).

5. The display substrate according to claim 3 or 4, wherein a distance between one second connection line (420) closest to the second group of connection lines (4202) in the first group of connection lines (4201) and one second connection line (420) closest to the first group of connection lines (4201) in the second group of connection lines (4202) is a first distance, a distance between two adjacent second connection lines (420) in the second group of connection lines (4202) is a second distance, and a ratio of the first distance to the second distance is greater than 2.

6. The display substrate according to claim 3, wherein the first connection line (410) connected with one second connection line (420) closest to the second group of connection lines (4202) in the first group of connection lines (4201) comprises two portions respectively located on both sides of the one second connection line (420) in the first direction;
optionally, the first connection line (410) connected with the one second connection line (420) closest to the second group of connection lines (4202) in the first group of connection lines (4201) extends to a position of one second connection line (420) closest to the first group of connection lines (4201) in the second group of connection lines (4202).

7. The display substrate according to claim 6, wherein each first connection line (410) among N first connection lines (410) respectively connected with N second connection lines (420) closest to the second group of connection lines (4202) in the first group of connection lines (4201) comprises two portions respectively located on both sides of a second connection line (420) connected with the each first connection line (410) in the first direction; among the N first connection lines (410) arranged along a direction approaching the second region (102), a length of a portion of the first connection line (410) located on one side, close to the second group of connection lines (4202), of the second connection line (420) connected with the first connection line (410) is gradually reduced, where N is a positive integer greater than or equal to 1, and a count of second connection lines (420) in the first group of connection lines (4201) located on one side of a center of the second region (102) is greater than or equal to N.

8. The display substrate according to any one of claims 3-7, wherein one second signal line (300) closest to the second region (102) among part of the plurality of second signal lines (300) whose extension lines do not pass through the second region (102) is located between one fourth connection line (440) closest to the second region (102) and another fourth connection line (440) adjacent to the one fourth connection line (440).

9. The display substrate according to any one of claims 1-8, wherein, on a same side of the second region (102), at least one first signal line (200) whose extension line does not pass through the second region (102) among the plurality of first signal lines (200) is located on one side of the first connection line (410) close to the second region (102).

10. The display substrate according to any one of claims 1-9, wherein, in the first region (101), at least one first connection line (410) and at least one third connection line (430) are in a same layer, and at least one second connection line (420) and at least one fourth connection line (440) are in a same layer;
optionally,
at least one first connection line (410) and at least one third connection line (430) are located in the same layer as the plurality of first signal lines (200); or,
the plurality of second signal lines (300) are located between the plurality of first signal lines (200) and the base substrate (100), and the fourth connection line (440) is located between the plurality of first signal lines (200) and the plurality of second signal lines (300).

11. The display substrate according to any one of claims 3-8, wherein the first region (101) is a display region, the first region (101) surrounds the second region (102), the base substrate (100) further comprises a peripheral region (103) surrounding the display region, the plurality of second group of connection lines (4202) comprise the second connection line (420) located in the first region (101) and the second connection line (420) located in the peripheral region (103), the second connection line (420) located in the first region (101) is arranged in a different layer from the first connection line (410), and the second connection line (420) located in the peripheral region (103) is arranged in the same layer as the first connection line (410).

12. The display substrate according to claim 2, further comprising:
a light-emitting element (120) and a pixel circuit (110) located on the base substrate (100), the pixel circuit (110) being electrically connected with the light-emitting element (120);
wherein the pixel circuit (110) comprises a driving transistor, a light-emitting control transistor and a reset transistor, a gate electrode of the light-emitting control transistor is electrically connected with the light-emitting control signal line, a first electrode of the light-emitting control transistor is electrically connected with a first electrode of the driving transistor, and a second electrode of the light-emitting control transistor is electrically connected with the light-emitting element (120);
a gate electrode of the reset transistor is electrically connected with a reset control signal line, and one electrode of the reset transistor is electrically connected with a second electrode of the driving transistor, or one electrode of the reset transistor is electrically connected with the second electrode of the light-emitting control transistor;
the plurality of second signal lines (300) comprise the reset control signal line.

13. The display substrate according to claim 1, further comprising:
a light-emitting element (120) and a pixel circuit (110) located on the base substrate (100), the pixel circuit (110) being electrically connected with the light-emitting element (120);
wherein the pixel circuit (110) comprises at least one N-type thin film transistor and at least one P-type thin film transistor; the plurality of second signal lines (300) comprise a signal line connected with a gate electrode of the at least one P-type thin film transistor; or,
the pixel circuit (110) comprises at least one oxide thin film transistor and at least one low temperature poly-silicon thin film transistor; the plurality of second signal lines (300) comprise a signal line connected with a gate electrode of the at least one low temperature poly-silicon thin film transistors.

14. The display substrate according to any one of claims 1-13, wherein the first region (101) is a display region, the first region (101) surrounds the second region (102), the base substrate (100) further comprises a peripheral region (103) surrounding the display region;
the display substrate further comprises a plurality of fifth connection lines (450) extending along the first direction and a plurality of sixth connection lines (460) extending along the second direction, the fifth connection line (450) located in the same layer and on the same straight line as the first connection line (410) is spaced apart from the first connection line (410), the fifth connection line (450) located in the same layer and on the same straight line as the third connection line (430) is spaced apart from the third connection line (430), the sixth connection line (460) located in the same layer and on the same straight line as the second connection line (420) is spaced apart from the second connection line (420), the sixth connection line (460) located in the same layer and on the same straight line as the fourth connection line (440) is spaced apart from the fourth connection line (440), at least one of the fifth connection line (450) and the sixth connection line (460) is electrically connected with a third signal line (600), and the third signal line (600) is located in the peripheral region (103).

15. A display apparatus, comprising the display substrate according to any one of claims 1-14.

## Patentansprüche

1. Anzeigesubstrat, umfassend:
ein Basissubstrat (100), umfassend einen ersten Bereich (101) und einen zweiten Bereich (102), wobei sich der erste Bereich (101) an einem Rand des zweiten Bereichs (102) befindet;
eine Vielzahl von ersten Signalleitungen (200), die sich auf dem Basissubstrat (100) befinden und nicht durch den zweiten Bereich (102) verlaufen;
eine Vielzahl von zweiten Signalleitungen (300), die sich in einer anderen Schicht als die Vielzahl von ersten Signalleitungen (200) befinden und nicht durch den zweiten Bereich (102) verlaufen,
wobei sich mindestens ein Teil der Vielzahl von ersten Signalleitungen (200) entlang einer ersten Richtung erstreckt, sich mindestens ein Teil der Vielzahl von zweiten Signalleitungen (300) entlang einer zweiten Richtung erstreckt und sich die erste Richtung mit der zweiten Richtung schneidet;
die Vielzahl von ersten Signalleitungen (200) einen Teil der ersten Signalleitungen (200) umfassen, deren Verlängerungslinien durch den zweiten Bereich (102) verlaufen, wobei jede erste Signalleitung (200) des Teils der ersten Signalleitungen (200) eine erste Untersignalleitung (210) und eine zweite Untersignalleitung (220) umfasst, die sich auf beiden Seiten des zweiten Bereichs (102) befinden, wobei die erste Untersignalleitung (210) und die zweite Untersignalleitung (220) durch eine erste Verbindungsleitung (410), die sich in der ersten Richtung erstreckt, und eine zweite Verbindungsleitung (420), die sich in der zweiten Richtung erstreckt, elektrisch verbunden sind, und der Teil der ersten Signalleitungen (200) mit einer Vielzahl von ersten Verbindungsleitungen (410) und einer Vielzahl von zweiten Verbindungsleitungen (420) elektrisch verbunden sind;
die Vielzahl von zweiten Signalleitungen (300) einen Teil von zweiten Signalleitungen (300) umfasst, deren Verlängerungslinien durch den zweiten Bereich (102) verlaufen, jede zweite Signalleitung (300) des Teils der zweiten Signalleitungen (300) eine dritte Untersignalleitung (310) und eine vierte Untersignalleitung (320) umfasst, die sich auf beiden Seiten des zweiten Bereichs (102) befinden, wobei die dritte Untersignalleitung (310) und die vierte Untersignalleitung (320) durch eine dritte Verbindungsleitung (430), die sich in der ersten Richtung erstreckt, und eine vierte Verbindungsleitung (440), die sich in der zweiten Richtung erstreckt, elektrisch verbunden sind, und der Teil der zweiten Signalleitungen (300) mit einer Vielzahl von dritten Verbindungsleitungen (430) und einer Vielzahl von vierten Verbindungsleitungen (440) elektrisch verbunden sind;
in einer Richtung senkrecht zu dem Basissubstrat (100) mindestens eine zweite Verbindungsleitung (420) mindestens mit einer dritten Verbindungsleitung (430) überlappt und auf einer gleichen Seite des zweiten Bereichs (102) mindestens eine erste Verbindungsleitung (410) sich an einer Seite von mindestens einer dritten Verbindungsleitung (430) entfernt von dem zweiten Bereich (102) befindet.

2. Anzeigesubstrat gemäß Anspruch 1, wobei die Vielzahl von ersten Signalleitungen (200) eine Datenleitung umfassen und die Vielzahl von zweiten Signalleitungen (300) mindestens eine Lichtemissionssteuerleitung umfassen;
optional ein Mindestabstand zwischen einer vierten Verbindungsleitung (440), die dem zweiten Bereich (102) am nächsten ist, und einem Rand des zweiten Bereichs (102) kleiner ist als ein Mindestabstand zwischen einer ersten Verbindungsleitung (410), die dem zweiten Bereich (102) am nächsten ist, und einem Rand des zweiten Bereichs (102).

3. Anzeigesubstrat gemäß einem der Ansprüche 1-2, wobei auf einer gleichen Seite des zweiten Bereichs (102) eine erste Gruppe von Verbindungsleitungen (4201) aus der Vielzahl von zweiten Verbindungsleitungen (420) sich auf einer Seite von mindestens einer vierten Verbindungsleitung (440) nahe zu dem zweiten Bereich (102) befinden und eine zweite Gruppe von Verbindungsleitungen (4202) aus der Vielzahl von zweiten Verbindungsleitungen (420) sich auf einer Seite von der mindestens einen vierten Verbindungsleitung (440) entfernt von dem zweiten Bereich (102) befinden.

4. Anzeigesubstrat gemäß Anspruch 3, wobei in der Richtung senkrecht zu dem Basissubstrat (100) die erste Gruppe von Verbindungsleitungen (4201) mit der dritten Verbindungsleitung (430) überlappt und die zweite Gruppe von Verbindungsleitungen (4202) mit der dritten Verbindungsleitung (430) nicht überlappt.

5. Anzeigesubstrat gemäß Anspruch 3 oder 4, wobei ein Abstand zwischen einer zweiten Verbindungsleitung (420), am nächsten zu der zweiten Gruppe von Verbindungsleitungen (4202) in der ersten Gruppe von Verbindungsleitungen (4201) und einer zweiten Verbindungsleitung (420), am nächsten zu der ersten Gruppe von Verbindungsleitungen (4201) in der zweiten Gruppe von Verbindungsleitungen (4202) ein erster Abstand ist, ein Abstand zwischen zwei benachbarten zweiten Verbindungsleitungen (420) in der zweiten Gruppe von Verbindungsleitungen (4202) ein zweiter Abstand ist und ein Verhältnis des ersten Abstands zu dem zweiten Abstand größer als 2 ist.

6. Anzeigesubstrat gemäß Anspruch 3, wobei die erste Verbindungsleitung (410), die verbunden ist mit einer zweiten Verbindungsleitung (420) am nächsten zu der zweiten Gruppe von Verbindungsleitungen (4202) in der ersten Gruppe von Verbindungsleitungen (4201) zwei Abschnitte umfasst, die sich jeweils auf beiden Seiten der einen zweiten Verbindungsleitung (420) in der ersten Richtung befinden;
optional sich die erste Verbindungsleitung (410), die verbunden ist mit der einen zweiten Verbindungsleitung (420) am nächsten zu der zweiten Gruppe von Verbindungsleitungen (4202) in der ersten Gruppe von Verbindungsleitungen (4201) bis zu einer Position einer zweiten Verbindungsleitung (420) am nächsten zu der ersten Gruppe von Verbindungsleitungen (4201) in der zweiten Gruppe von Verbindungsleitungen (4202) erstreckt.

7. Anzeigesubstrat gemäß Anspruch 6, wobei jede erste Verbindungsleitung (410) unter N ersten Verbindungsleitungen (410), die jeweils mit N zweiten Verbindungsleitungen (420) verbunden ist am nächsten zu der zweiten Gruppe von Verbindungsleitungen (4202) in der ersten Gruppe von Verbindungsleitungen (4201) zwei Abschnitte umfasst, die sich jeweils auf beiden Seiten einer zweiten Verbindungsleitung (420) verbunden mit der jeweiligen ersten Verbindungsleitung (410) in der ersten Richtung befinden; unter den N ersten Verbindungsleitungen (410), die entlang einer Richtung angeordnet sind, die sich dem zweiten Bereich (102) nähert, eine Länge eines Abschnitts der ersten Verbindungsleitung (410), lokalisiert auf einer Seite nahe der zweiten Gruppe von Verbindungsleitungen (4202), der zweiten Verbindungsleitung (420), verbunden mit der ersten Verbindungslinie (410) allmählich verringert ist, wobei N eine positive ganze Zahl größer als oder gleich 1 ist und eine Anzahl von zweiten Verbindungslinien (420) in der ersten Gruppe von Verbindungslinien (4201), lokalisiert auf einer Seite eines Zentrums des zweiten Bereichs (102), größer als oder gleich N ist.

8. Anzeigesubstrat gemäß einem der Ansprüche 3 bis 7, wobei eine zweite Signalleitung (300) am nächsten zu dem zweiten Bereich (102) unter einem Teil von der Vielzahl von zweiten Signalleitungen (300), deren Verlängerungslinien nicht durch den zweiten Bereich (102) verlaufen, sich zwischen einer vierten Verbindungsleitung (440) am nächsten zu dem zweiten Bereich (102) und einer anderen vierten Verbindungsleitung (440) benachbart zu der einen vierten Verbindungsleitung (440) befindet.

9. Anzeigesubstrat gemäß einem der Ansprüche 1 bis 8, wobei auf einer gleichen Seite des zweiten Bereichs (102) mindestens eine erste Signalleitung (200), deren Verlängerungslinie nicht durch den zweiten Bereich (102) verläuft, aus der Vielzahl von ersten Signalleitungen (200) sich auf einer Seite der ersten Verbindungsleitung (410) nahe zu dem zweiten Bereich (102) befindet.

10. Anzeigesubstrat gemäß einem der Ansprüche 1 bis 9, wobei sich in dem ersten Bereich (101) mindestens eine erste Verbindungsleitung (410) und mindestens eine dritte Verbindungsleitung (430) in einer gleichen Schicht befinden und mindestens eine zweite Verbindungsleitung (420) und mindestens eine vierte Verbindungsleitung (440) in einer gleichen Schicht sind;
optional
sich mindestens eine erste Verbindungsleitung (410) und mindestens eine dritte Verbindungsleitung (430) in einer gleichen Schicht wie die Vielzahl von ersten Signalleitungen (200) befinden; oder
die Vielzahl von zweiten Signalleitungen (300) sich zwischen der Vielzahl von ersten Signalleitungen (200) und dem Basissubstrat (100) befinden und die vierte Verbindungsleitung (440) sich zwischen der Vielzahl von ersten Signalleitungen (200) und der Vielzahl von zweiten Signalleitungen (300) befindet.

11. Anzeigesubstrat gemäß einem der Ansprüche 3 bis 8, wobei der erste Bereich (101) ein Anzeigebereich ist, der erste Bereich (101) den zweiten Bereich (102) umgibt, das Basissubstrat (100) außerdem einen den Anzeigebereich umgebenden Randbereich (103) umfasst, die Vielzahl der zweiten Gruppe von Verbindungsleitungen (4202) die sich in dem ersten Bereich (101) befindende zweite Verbindungsleitung (420) und die sich in dem Randbereich (103) befindende zweite Verbindungsleitung (420) umfassen, die zweite Verbindungsleitung (420), die sich in dem ersten Bereich (101) befindet, in einer anderen Schicht als die erste Verbindungsleitung (410) angeordnet ist, und die zweite Verbindungsleitung (420), die sich in dem Randbereich (103) befindet, in der selben Schicht wie die erste Verbindungsleitung (410) angeordnet ist.

12. Anzeigesubstrat gemäß Anspruch 2, außerdem umfassend:
ein Lichtemissionselement (120) und eine Pixelschaltung (110), lokalisiert auf dem Basissubstrat (100), wobei die Pixelschaltung (110) elektrisch mit dem Lichtemissionselement (120) verbunden ist;
wobei die Pixelschaltung (110) einen Ansteuertransistor, einen Lichtemissions-Steuertransistor und einen Rücksetztransistor umfasst, eine Gate-Elektrode des Lichtemissions-Steuertransistors elektrisch mit der Lichtemissions-Steuersignalleitung verbunden ist, eine erste Elektrode des Lichtemissions-Steuertransistors elektrisch mit einer ersten Elektrode des Ansteuertransistors verbunden ist und eine zweite Elektrode des Lichtemissions-Steuertransistors elektrisch mit dem Lichtemissionselement (120) verbunden ist;
eine Gate-Elektrode des Rücksetztransistors elektrisch mit einer Rücksetzsteuersignalleitung verbunden ist und eine Elektrode des Rücksetztransistors elektrisch mit einer zweiten Elektrode des Ansteuertransistors verbunden ist oder eine Elektrode des Rücksetztransistors elektrisch mit der zweiten Elektrode des Lichtemissions-Steuertransistors verbunden ist;
die Vielzahl von zweiten Signalleitungen (300) die Rücksetzsteuersignalleitung umfassen.

13. Anzeigesubstrat gemäß Anspruch 1, außerdem umfassend:
ein Lichemissionselement (120) und eine Pixelschaltung (110), die sich auf dem Basissubstrat (100) befinden, wobei die Pixelschaltung (110) elektrisch mit dem Lichtemissionslement (120) verbunden ist;
wobei die Pixelschaltung (110) mindestens einen N-Typ-Dünnschichttransistor und mindestens einen P-Typ-Dünnschichttransistor umfasst; die Vielzahl von zweiten Signalleitungen (300) eine Signalleitung umfassen, die mit einer Gate-Elektrode des mindestens einen P-Typ-Dünnschichttransistors verbunden ist; oder
die Pixelschaltung (110) mindestens einen Oxid-Dünnschichttransistor und mindestens einen Niedertemperatur-Polysilizium-Dünnschichttransistor umfasst; die Vielzahl von zweiten Signalleitungen (300) eine Signalleitung umfassen, die mit einer Gate-Elektrode des mindestens einen Niedertemperatur-Polysilizium-Dünnschichttransistors verbunden ist.

14. Anzeigesubstrat gemäß einem der Ansprüche 1 bis 13, wobei der erste Bereich (101) ein Anzeigebereich ist, der erste Bereich (101) den zweiten Bereich (102) umgibt und das Basissubstrat (100) außerdem einen den Anzeigebereich umgebenden Randbereich (103) umfasst.
das Anzeigesubstrat außerdem eine Vielzahl von fünften Verbindungsleitungen (450), die sich entlang der ersten Richtung erstrecken, und eine Vielzahl von sechsten Verbindungsleitungen (460), die sich entlang der zweiten Richtung erstrecken, umfasst, wobei sich die fünfte Verbindungsleitung (450), die sich in derselben Schicht und auf derselben Geraden wie die erste Verbindungsleitung (410) befindet, von der ersten Verbindungsleitung (410) beabstandet ist, die fünfte Verbindungsleitung (450), die sich in derselben Schicht und auf derselben Geraden wie die dritte Verbindungsleitung (430) befindet, von der dritten Verbindungsleitung (430) beabstandet ist, die sechste Verbindungsleitung (460), die sich in derselben Schicht und auf derselben Geraden wie die zweite Verbindungsleitung (420) befindet, von der zweiten Verbindungsleitung (420) beabstandet ist, die sechste Verbindungsleitung (460), die sich in derselben Schicht und auf derselben Geraden wie die vierte Verbindungsleitung (440) befindet, von der vierten Verbindungsleitung (440) beabstandet ist, mindestens eine der fünften Verbindungsleitung (450) und der sechsten Verbindungsleitung (460) elektrisch mit einer dritten Signalleitung (600) verbunden ist, und die dritte Signalleitung (600) sich in dem Randbereich (103) befindet.

15. Anzeigevorrichtung, umfassend das Anzeigesubstrat gemäß einem der Ansprüche 1 bis 14.

## Revendications

1. Substrat d'affichage comprenant :
un substrat de base (100), comprenant une première région (101) et une deuxième région (102), la première région (101) étant située en une périphérie de la deuxième région (102) ;
une pluralité de premières lignes de signal (200), situées sur le substrat de base (100) et ne traversant pas la deuxième région (102) ;
une pluralité de deuxièmes lignes de signal (300), situées dans une couche différente de la pluralité de premières lignes de signal (200) et ne traversant pas la deuxième région (102),
dans lequel au moins une partie de la pluralité de premières lignes de signal (200) s'étend le long d'une première direction, au moins une partie de la pluralité de deuxièmes lignes de signal (300) s'étend le long d'une deuxième direction, et la première direction croise la deuxième direction ;
la pluralité de premières lignes de signal (200) comprend une partie de premières lignes de signal (200) dont les lignes d'extension traversent la deuxième région (102), chaque première ligne de signal (200) de la partie de premières lignes de signal (200) comprend une première ligne de sous-signal (210) et une deuxième ligne de sous-signal (220) situées de part et d'autre de la deuxième région (102), la première ligne de sous-signal (210) et la deuxième ligne de sous-signal (220) sont électriquement connectées à travers une première ligne de raccordement (410) s'étendant dans la première direction et une deuxième ligne de raccordement (420) s'étendant dans la deuxième direction, et la partie de premières lignes de signal (200) est électriquement connectée à une pluralité de premières lignes de raccordement (410) et une pluralité de deuxièmes lignes de raccordement (420) ;
la pluralité de deuxièmes lignes de signal (300) comprend une partie de deuxièmes lignes de signal (300) dont les lignes d'extension traversent la deuxième région (102), chaque deuxième ligne de signal (300) de la partie de deuxièmes lignes de signal (300) comprend une troisième ligne de sous-signal (310) et une quatrième ligne de sous-signal (320) situées de part et d'autre de la deuxième région (102), la troisième ligne de sous-signal (310) et la quatrième ligne de sous-signal (320) sont électriquement connectées à travers une troisième ligne de raccordement (430) s'étendant dans la première direction et une quatrième ligne de raccordement (440) s'étendant dans la deuxième direction, et la partie de deuxièmes lignes de signal (300) est électriquement connectée à une pluralité de troisièmes lignes de raccordement (430) et une pluralité de quatrièmes lignes de raccordement (440) ;
dans une direction perpendiculaire au substrat de base (100), au moins une deuxième ligne de raccordement (420) chevauche au moins une troisième ligne de raccordement (430), et sur un même côté de la deuxième région (102), au moins une première ligne de raccordement (410) se situe sur un côté d'au moins une troisième ligne de raccordement (430) éloigné de la deuxième région (102).

2. Substrat d'affichage selon la revendication 1, dans lequel la pluralité de premières lignes de signal (200) comprend une ligne de données, et la pluralité de deuxièmes lignes de signal (300) comprend au moins une ligne de signal de commande d'émission de lumière ; en option, une distance minimale entre une quatrième ligne de raccordement (440) la plus proche de la deuxième région (102) et un bord de la deuxième région (102) est inférieure à une distance minimale entre une première ligne de raccordement (410) la plus proche de la deuxième région (102) et un bord de la deuxième région (102).

3. Substrat d'affichage selon l'une des revendications 1-2, dans lequel, sur un même côté de la deuxième région (102), un premier groupe de lignes de raccordement (4201) parmi la pluralité de deuxièmes lignes de raccordement (420) se situe sur un côté d'au moins une quatrième ligne de raccordement (440) proche de la deuxième région (102), et un second groupe de lignes de raccordement (4202) parmi la pluralité de deuxièmes lignes de raccordement (420) se situe sur un côté de l'au moins une quatrième ligne de raccordement (440) éloigné de la deuxième région (102).

4. Substrat d'affichage selon la revendication 3, dans lequel, dans la direction perpendiculaire au substrat de base (100), le premier groupe de lignes de raccordement (4201) chevauche la troisième ligne de raccordement (430), et le second groupe de lignes de raccordement (4202) ne chevauche pas la troisième ligne de raccordement (430).

5. Substrat d'affichage selon la revendication 3 ou 4, dans lequel une distance entre une deuxième ligne de raccordement (420) la plus proche du second groupe de lignes de raccordement (4202) dans le premier groupe de lignes de raccordement (4201) et une deuxième ligne de raccordement (420) la plus proche du premier groupe de lignes de raccordement (4201) dans le second groupe de lignes de raccordement (4202) est une première distance, une distance entre deux deuxièmes lignes de raccordement (420) adjacentes dans le second groupe de lignes de raccordement (4202) est une deuxième distance, et un rapport entre la première distance et la deuxième distance est supérieur à 2.

6. Substrat d'affichage selon la revendication 3, dans lequel la première ligne de raccordement (410) connectée à une deuxième ligne de raccordement (420) la plus proche du second groupe de lignes de raccordement (4202) dans le premier groupe de lignes de raccordement (4201) comprend deux portions situées respectivement de part et d'autre de l'une deuxième ligne de raccordement (420) dans la première direction ;
en option, la première ligne de raccordement (410) connectée à l'une deuxième ligne de raccordement (420) la plus proche du second groupe de lignes de raccordement (4202) dans le premier groupe de lignes de raccordement (4201) s'étend vers une position d'une deuxième ligne de raccordement (420) la plus proche du premier groupe de lignes de raccordement (4201) dans le second groupe de lignes de raccordement (4202).

7. Substrat d'affichage selon la revendication 6, dans lequel chaque première ligne de raccordement (410) parmi N premières lignes de raccordement (410) respectivement connectées à N deuxièmes lignes de raccordement (420) les plus proches du second groupe de lignes de raccordement (4202) dans le premier groupe de lignes de raccordement (4201) comprend deux portions situées respectivement de part et d'autre d'une deuxième ligne de raccordement (420) connectée à la chaque première ligne de raccordement (410) dans la première direction ; parmi les N premières lignes de raccordement (410) disposées le long d'une direction s'approchant de la deuxième région (102), une longueur d'une portion de la première ligne de raccordement (410) située sur un côté, proche du second groupe de lignes de raccordement (4202), de la deuxième ligne de raccordement (420) connectée à la première ligne de raccordement (410) est progressivement réduite, dans lequel N est un entier positif supérieur ou égal à 1, et un nombre de deuxièmes lignes de raccordement (420) dans le premier groupe de lignes de raccordement (4201) situé sur un côté d'un centre de la deuxième région (102) est supérieur ou égal à N.

8. Substrat d'affichage selon l'une des revendications 3-7, dans lequel une deuxième ligne de signal (300) la plus proche de la deuxième région (102) parmi une partie de la pluralité de deuxièmes lignes de signal (300) dont les lignes d'extension ne traversent pas la deuxième région (102) se situe entre une quatrième ligne de raccordement (440) la plus proche de la deuxième région (102) et une autre quatrième ligne de raccordement (440) adjacente à l'une quatrième ligne de raccordement (440).

9. Substrat d'affichage selon l'une des revendications 1-8, dans lequel, sur un même côté de la deuxième région (102), au moins une première ligne de signal (200) dont la ligne d'extension ne traverse pas la deuxième région (102) parmi la pluralité de premières lignes de signal (200) se situe sur un côté de la première ligne de raccordement (410) proche de la deuxième région (102).

10. Substrat d'affichage selon l'une des revendications 1-9, dans lequel, dans la première région (101), au moins une première ligne de raccordement (410) et au moins une troisième ligne de raccordement (430) sont dans une même couche, et au moins une deuxième ligne de raccordement (420) et au moins une quatrième ligne de raccordement (440) sont dans une même couche ;
en option,
au moins une première ligne de raccordement (410) et au moins une troisième ligne de raccordement (430) se situent dans la même couche que la pluralité de premières lignes de signal (200) ; ou
la pluralité de deuxièmes lignes de signal (300) se situent entre la pluralité de premières lignes de signal (200) et le substrat de base (100), et la quatrième ligne de raccordement (440) se situe entre la pluralité de premières lignes de signal (200) et la pluralité de deuxièmes lignes de signal (300).

11. Substrat d'affichage selon l'une des revendications 3-8, dans lequel la première région (101) est une région d'affichage, la première région (101) entoure la deuxième région (102), le substrat de base (100) comprend en outre une région périphérique (103) entourant la région d'affichage, la pluralité du second groupe de lignes de raccordement (4202) comprend la deuxième ligne de raccordement (420) située dans la première région (101) et la deuxième ligne de raccordement (420) située dans la région périphérique (103), la deuxième ligne de raccordement (420) située dans la première région (101) est disposée dans une couche différente de la première ligne de raccordement (410), et la deuxième ligne de raccordement (420) située dans la région périphérique (103) est disposée dans la même couche que la première ligne de raccordement (410).

12. Substrat d'affichage selon la revendication 2, comprenant en outre :
un élément émetteur de lumière (120) et un circuit de pixels (110) situés sur le substrat de base (100), le circuit de pixels (110) étant électriquement connecté à l'élément émetteur de lumière (120) ;
dans lequel le circuit de pixels (110) comprend un transistor de commande, un transistor de commande d'émission de lumière et un transistor de réinitialisation, une électrode de grille du transistor de commande d'émission de lumière est électriquement connectée à la ligne de signal de commande d'émission de lumière, une première électrode du transistor de commande d'émission de lumière est électriquement connectée à une première électrode du transistor de commande, et une deuxième électrode du transistor de commande d'émission de lumière est électriquement connectée à l'élément émetteur de lumière (120) ;
une électrode de grille du transistor de réinitialisation est électriquement connectée à une ligne de signal de commande de réinitialisation, et une électrode du transistor de réinitialisation est électriquement connectée à une deuxième électrode du transistor de commande, ou une électrode du transistor de réinitialisation est électriquement connectée à la deuxième électrode du transistor de commande d'émission de lumière ;
la pluralité de deuxièmes lignes de signal (300) comprend la ligne de signal de commande de réinitialisation.

13. Substrat d'affichage selon la revendication 1, comprenant en outre :
un élément émetteur de lumière (120) et un circuit de pixels (110) situés sur le substrat de base (100), le circuit de pixels (110) étant électriquement connecté à l'élément émetteur de lumière (120) ;
dans lequel le circuit de pixels (110) comprend au moins un transistor en couches minces de type N et au moins un transistor en couches minces de type P ; la pluralité de deuxièmes lignes de signal (300) comprend une ligne de signal connectée à une électrode de grille de l'au moins un transistor en couches minces de type P ; ou
le circuit de pixels (110) comprend au moins un transistor en couches minces d'oxyde et au moins un transistor en couches minces de polysilicium à basse température ; la pluralité de deuxièmes lignes de signal (300) comprend une ligne de signal connectée à une électrode de grille de l'au moins un transistor en couches minces de polysilicium à basse température.

14. Substrat d'affichage selon l'une des revendications 1-13, dans lequel la première région (101) est une région d'affichage, la première région (101) entoure la deuxième région (102), le substrat de base (100) comprend en outre une région périphérique (103) entourant la région d'affichage ;
le substrat d'affichage comprend en outre une pluralité de cinquièmes lignes de raccordement (450) s'étendant le long de la première direction et une pluralité de sixièmes lignes de raccordement (460) s'étendant le long de la deuxième direction, la cinquième ligne de raccordement (450) située dans la même couche et sur la même ligne droite que la première ligne de raccordement (410) est espacée de la première ligne de raccordement (410), la cinquième ligne de raccordement (450) située dans la même couche et sur la même ligne droite que la troisième ligne de raccordement (430) est espacée de la troisième ligne de raccordement (430), la sixième ligne de raccordement (460) située dans la même couche et sur la même ligne droite que la deuxième ligne de raccordement (420) est espacée de la deuxième ligne de raccordement (420), la sixième ligne de raccordement (460) située dans la même couche et sur la même ligne droite que la quatrième ligne de raccordement (440) est espacée de la quatrième ligne de raccordement (440), au moins une de la cinquième ligne de raccordement (450) et de la sixième ligne de raccordement (460) est électriquement connectée à une troisième ligne de signal (600), et la troisième ligne de signal (600) se situe dans la région périphérique (103).

15. Appareil d'affichage, comprenant le substrat d'affichage selon l'une des revendications 1-14.
